(19) Europäisches Patentamt / European Patent Office / Office européen des brevets

(11) **EP 2 795 826 B1**

(12) **FASCICULE DE BREVET EUROPEEN**

(45) Date de publication et mention de la délivrance du brevet:
**22.04.2020 Bulletin 2020/17**

(21) Numéro de dépôt: **12819102.0**

(22) Date de dépôt: **20.12.2012**

(51) Int Cl.:
*H04L 5/00* (2006.01)　　　*H04L 1/00* (2006.01)
*H04B 7/02* (2018.01)

(86) Numéro de dépôt international:
**PCT/FR2012/053025**

(87) Numéro de publication internationale:
**WO 2013/093359 (27.06.2013 Gazette 2013/26)**

(54) **PROCÉDÉ DE TRANSMISSION D'UN SIGNAL NUMÉRIQUE POUR UN SYSTÈME MS-MARC SEMI-ORTHOGONAL, PRODUIT PROGRAMME ET DISPOSITIF RELAIS CORRESPONDANTS**

VERFAHREN ZUR ÜBERTRAGUNG EINES DIGITALEN SIGNALS FÜR EIN HALBORTHOGONALES MS-MARC-SYSTEM UND ZUGEHÖRIGES PROGRAMMPRODUKT SOWIE RELAISVORRICHTUNG

METHOD OF TRANSMITTING A DIGITAL SIGNAL FOR A SEMI-ORTHOGONAL MS-MARC SYSTEM, AND CORRESPONDING PROGRAMME PRODUCT AND RELAY DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2011 FR 1162201**

(43) Date de publication de la demande:
**29.10.2014 Bulletin 2014/44**

(73) Titulaire: **Orange**
**75015 Paris (FR)**

(72) Inventeurs:
• **BENAMMAR, Meryem**
**F-91400 Orsay (FR)**
• **HATEFI, Atoosa**
**F-75015 Paris (FR)**
• **VISOZ, Raphaël**
**F-92170 Vanves (FR)**

(56) Documents cités:
• **ATOOSA HATEFI ET AL: "Full Diversity Distributed Coding for the Multiple Access Half-Duplex Relay Channel", NETWORK CODING (NETCOD), 2011 INTERNATIONAL SYMPOSIUM ON, IEEE, 25 juillet 2011 (2011-07-25), pages 1-6, XP031928315, DOI: 10.1109/ISNETCOD.2011.5979061 ISBN: 978-1-61284-138-0**
• **HATEFI A ET AL: "Joint Channel-Network Coding for the Semi-Orthogonal Multiple Access Relay Channel", VEHICULAR TECHNOLOGY CONFERENCE FALL (VTC 2010-FALL), 2010 IEEE 72ND, IEEE, PISCATAWAY, NJ, USA, 6 septembre 2010 (2010-09-06), pages 1-5, XP031770127, ISBN: 978-1-4244-3573-9**

## Description

### Domaine de l'invention

La présente invention se rapporte au domaine des télécommunications. Au sein de ce domaine, l'invention se rapporte plus particulièrement à la transmission de données codées dans un réseau MS-MR, abréviation de multi sources multi relais. Un réseau MS-MR est un système de télécommunication qui, pour une destination donnée, comprend au moins quatre nœuds : au moins deux sources et au moins deux relais. L'invention traite de codage de réseau. Elle concerne l'amélioration de la qualité de la transmission des données, et en particulier l'amélioration des performances du décodage correcteur d'erreurs au niveau de la destination.

L'invention s'applique notamment, mais non exclusivement, à la transmission de données via des réseaux mobiles, par exemple pour des applications temps réel.

### Art antérieur

Les réseaux, en particulier mobiles, sont à la recherche de gains significatifs en termes de capacité, de fiabilité, de consommation et autres. Le canal de transmission d'un réseau mobile est réputé difficile et conduit à une fiabilité de transmission relativement médiocre. Des progrès importants ont été réalisés ces dernières années, en matière de codage et de modulation, notamment pour des considérations de consommation et de capacité. En effet, dans un réseau mobile où plusieurs sources/destinations partagent les mêmes ressources (temps, fréquence et espace) il faut réduire au maximum la puissance d'émission.

Cette réduction va à l'encontre de la couverture et donc de la capacité du système et plus généralement de ses performances.

Pour augmenter la couverture, fiabiliser les communications et plus généralement améliorer les performances, une approche consiste à s'appuyer sur des relais pour augmenter l'efficacité spectrale et donc améliorer l'efficacité de la transmission et la fiabilité des systèmes.

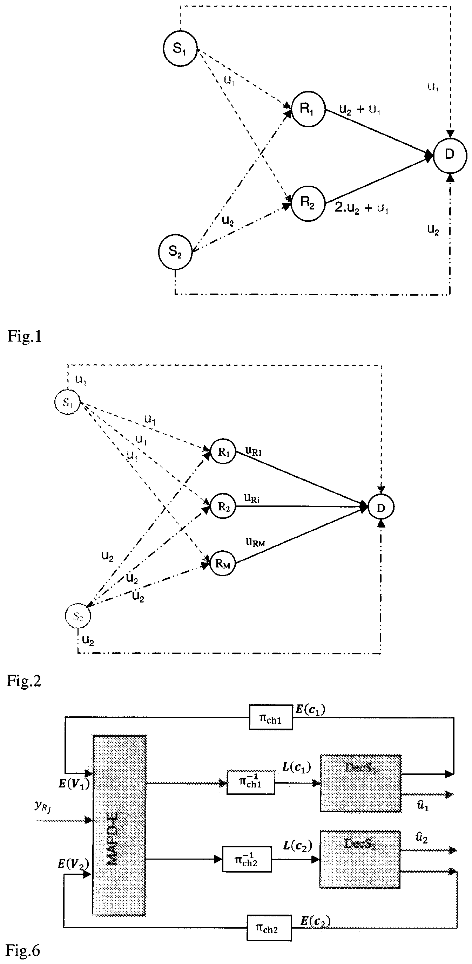

La topologie de base d'un système MS-MR illustrée par la figure 1 est telle que les sources, nœuds $S_1$ et $S_2$, diffusent leurs séquences d'informations codées à l'attention des relais $R_1$ et $R_2$ et du destinataire D; les sources sont typiquement des terminaux d'utilisateurs qui cherchent à joindre une même station de base en s'aidant de relais. Chaque relais décode les signaux reçus issus des sources, $S_1$ à $S_2$, et ré-encode conjointement les séquences issues du décodage en ajoutant une redondance propre créant un code de réseau. A la destination D, le décodage des séquences codées spatialement distribuées, comprenant les séquences codées reçues issues directement des sources $S_1$ et $S_2$ et les séquences codées issues des relais $R_1$ et $R_2$, repose sur des algorithmes de décodage canal et de décodage réseau.

Le codage de réseau est une forme de coopération selon laquelle les nœuds du réseau partagent non seulement leurs ressources propres (puissance, bande, etc.) mais également leur capacité de calcul, pour créer un codage distribué de plus en plus puissant au fur et à mesure que l'information se propage à travers les nœuds. Il amène des gains substantiels en termes de diversité et de codage et donc de fiabilité de transmission.

Une difficulté majeure réside en ce que les liens des sources vers les relais ne permettent pas toujours de détecter les messages des sources sans erreur par tous les relais à partir des signaux reçus. Cette difficulté se rencontre par exemple dans le cas d'un canal de transmission sources/relais à évanouissements de Rayleigh avec absence de connaissance du canal au niveau des sources. Dans ce cas il existe une probabilité non nulle dite de coupure (« outage » selon la terminologie anglosaxonne) que les relais décodent imparfaitement les messages des sources. Cette imperfection peut provoquer des propagations d'erreurs vers la destination.

En outre, l'atteinte de la diversité maximale nécessite de pouvoir récupérer tous les messages des sources en cas de coupure sur un nombre de liens égal au nombre de relais.

L'article [1] évoque un codage réseau pour un système MS-MR simple illustré par la figure 1. Ce système MS-MR correspond à la topologie de base. Le système est limité à deux sources et deux relais. Le système MS-MR considéré est tel que tous les liens sources/destination et relais destination sont orthogonaux et utilisent des ressources spectrales différentes (c'est-à-dire que les ressources radio utilisées entre sources et relais sont séparées en temps ou en fréquence). Cette séparation entraîne une perte d'efficacité spectrale puisque la ressource radio est divisée entre plusieurs utilisateurs.

Les deux sources S1, S2 diffusent l'information codée aux relais R1, R2 et au destinataire D. Les relais R1, R2 combinent linéairement les flux supposés parfaitement décodés des deux utilisateurs selon un schéma de codage de réseau linéaire définit dans un corps fini d'ordre 4. Ce codage de réseau permet d'atteindre la diversité maximale qui est de trois (M+1) car n'importe lequel des couples de deux codes pris parmi les quatre codes 11, 12, 1+12 et 11+212 suffit pour reconstituer les messages I1 et 12 provenant des sources, en cas de coupure de deux liens.

Dans ce système, les erreurs de décodage peuvent être réduites uniquement en l'absence d'interférence puisque le système MS-MR considéré purement théorique est supposé sans interférence du fait des liens totalement orthogonaux. En outre, la contrainte qui consiste à imposer des liens totalement orthogonaux conduit à une utilisation non optimale de la ressource spectrale donc à une limitation de la capacité du réseau.

Les relais des systèmes MS-MR peuvent tout aussi bien être des relais fixes que des relais mobiles. Compte tenu de la densité de communications à transmettre dans des zones fortement peuplées, le nombre de relais peut être important et très supérieur à deux. En effet, pour couvrir de telles zones, des relais fixes peuvent être utilisés de préférence à des stations de base dont le coût peut être nettement supérieur. De manière alternative, des relais mobiles peuvent être utilisés. Ces relais mobiles sont typiquement des terminaux mobiles. Un tel système MS-MR devient très complexe et un procédé de transmission selon [1] est très consommateur en ressources ce qui rend le système peu attractif. Les articles ATOOSA HATEFI ET AL: «Full diversity distributed coding for the multiple access half duplex relay channel », NETWORK CODING (NETCOD), 2011 INTERNATIONAL SYMPOSIUM ON, IEEE, 25 juillet 2011, pages 1-6, et FIATEFI A ET AL: « Joint channel-network coding for the semi-orthogonal multiple access relay channel », VEHICULAR TECHNOLOGY CONFERENCE FALL (VTC 2010-FALL), 2010 IEEE 72nd, IEEE, PISCATAWAY, NJ, USA, 6 septembre 2010, pages 1-5, divulguent un système MARC semi orthogonal comprenant un relais sélectif, le relais effectuant une detection/décodage conjointe iterative, entrelaçant les messages décodés correctement et les codant avec un code linéaire binaire dans un corps fini d'ordre 2 avant de transmettre un signal représentatif du résultat du codage.

## Caractéristiques principales de l'invention

L'invention a pour objet un procédé de transmission semi orthogonal d'un signal destiné à un système à N sources, M relais et un seul récepteur selon lequel la transmission simultanée sur une même ressource spectrale par les relais est successive et non simultanée à une transmission simultanée sur une même ressource spectrale par les sources, le procédé comprenant par relais :

- une étape de détection/décodage conjoint itératif de messages émis respectivement par les sources pour obtenir des messages décodés,
- une étape de détection d'erreurs sur les messages décodés,
- une étape d'entrelacement des messages détectés sans erreur suivie d'une étape de codage réseau algébrique consistant en une combinaison linéaire dans un corps fini d'ordre strictement supérieur à deux des messages entrelacés pour obtenir un message codé,
  les combinaisons linéaires étant indépendantes deux par deux entre les relais du système.
- une étape de mise en forme comprenant un codage canal pour générer un signal représentatif du message codé réseau.

Une transmission selon l'invention est adaptée pour un système à au moins deux relais qui relaient des messages provenant d'au moins deux sources vers une seule destination. Le système est dit multi utilisateurs multi relais. Le protocole de transmission est qualifié de semi orthogonal car il se déroule en deux phases. Pendant la première phase, les sources émettent simultanément en occupant une même ressource spectrale. Les relais et la destination écoutent, détectent et décodent. Les signaux transmis interfèrent d'une part aux relais et d'autre part à la destination. Pendant la seconde phase, les sources se taisent, les relais transmettent simultanément en occupant la même ressource spectrale. Les signaux transmis interfèrent à la destination. Les liens sources/relais, les liens relais/destination et les liens sources/destination sont non orthogonaux. La qualification de semi orthogonalité vient des deux phases de transmission qui évitent toute interférence à la destination entre les signaux provenant des sources et les signaux provenant des relais.

Le codage réseau permet avantageusement d'atteindre l'ordre de diversité maximal qui est de M+1 pour un système à M relais ; l'ordre maximal est donné par le nombre de chemins différents que peut suivre le signal émis par une des sources vers la destination (le chemin direct et M chemins par l'intermédiaire des M relais). En effet, l'indépendance deux à deux des combinaisons linéaires définies dans un corps fini d'ordre supérieur à deux mises en œuvre par les relais permet d'atteindre un ordre de diversité égal à M+1 puisque la suppression de M liens parmi les M+1 permet toujours à la destination de retrouver les signaux sources compte tenu du caractère inversible du système linéaire construit.

Dans un système à deux relais selon l'art antérieur, l'utilisation d'une fonction Xor ($\oplus$) au niveau de chacun des relais pour effectuer la combinaison ne permet pas d'atteindre une diversité maximale. En effet, lorsque les deux liens source/destination sont coupés il n'est pas possible de reconstituer à la destination les messages I1 et I2 provenant des deux sources à partir des messages I1$\oplus$I2 provenant des relais. L'information I1$\oplus$I2 reçue à la destination provenant des relais ne permet pas de reconstituer 11 ni 12 en l'absence de l'information 11 ou 12 reçue directement des sources. Contrairement aux techniques connues de l'art antérieur, l'invention est adaptée à un nombre de relais quelconque supérieur ou égal à deux.

L'invention permet de maximiser l'efficacité spectrale en autorisant des collisions des signaux aux relais et à la destination compte tenu respectivement d'une transmission simultanée par les sources sur une même ressource spectrale et d'une transmission simultanée par les relais sur une même ressource spectrale. Ainsi, l'invention tient compte non seulement de liens sources relais et sources destination non orthogonaux mais en outre de liens relais destination non orthogonaux. L'optimisation de l'efficacité spectrale est atteinte lorsque les sources et les relais occupent les mêmes ressources spectrales lors de leurs transmissions respectives, ceci correspond à un mode particulier de réalisation de l'invention.

L'invention permet en outre d'effectuer à la destination un décodage canal/réseau conjoint itératif compte tenu de l'entrelacement effectué par le relais avant le codage réseau. L'entrelacement de chaque message reçu sans erreur diminue la corrélation entre le codage canal effectué aux sources sur les mêmes messages non entrelacés et le codage canal/réseau effectué aux relais sur ces mêmes messages. Par conséquent, ceci assure qu'un décodage conjoint canal/réseau à la destination qui exploite d'une part les signaux provenant directement des sources et d'autre part les signaux provenant des relais soit plus performant qu'un décodage canal effectué de manière indépendante à un décodage réseau.

Le relayage selon l'invention permet une augmentation de la fiabilité des transmissions entre les sources et la destination tout en minimisant la propagation d'erreurs des relais vers la destination compte tenu du caractère adaptatif du codage réseau. Un tel procédé est donc particulièrement adapté à un système déployé en milieu urbain dans lequel le canal de transmission a généralement un profil à évanouissements dit de Rayleigh. En effet, de tels évanouissements perturbent le signal transmis et se traduisent par une probabilité non nulle de détection erronée (probabilité dite de coupure ou d' « outage » selon la terminologie anglosaxonne). Un procédé de relayage adaptatif (ou sélectif) selon l'invention permet avantageusement de ne pas transmettre d'information par le relais si tous les messages reçus sont erronés tout en permettant de transmettre par le relais une information représentative d'une source même si seul le message provenant de cette source est détecté non erroné. Le procédé tient donc compte de liens sources-relais bruités.

L'invention est particulièrement adaptée à des relais half duplex mais peut tout aussi bien être mise en œuvre avec des relais full duplex. Les systèmes coopératifs utilisant des relais half duplex sont très attractifs du fait de schémas de communication plus simples que pour des relais full duplex, d'une mise en œuvre facile et d'un coût réduit.

L'invention a en outre pour objet un relais destiné à un système MS-MR semi-orthogonal.

Ainsi, un relais selon l'invention, destiné à la mise en œuvre d'un procédé de transmission selon l'invention, comprend :

- un moyen de détection/décodage conjoint itératif pour séparer les flux provenant des sources et déterminer, par flux, un message représentatif d'un mot de code émis par une source,
- un moyen de détection d'erreur pour garder uniquement les messages détectés sans erreur,
- un moyen d'entrelacement pour entrelacer les messages détectés sans erreur,
- un moyen de codage réseau algébrique des messages entrelacés,
- un moyen de mise en forme comprenant un codage de canal des messages issus du codage réseau pour générer un signal représentatif des messages codés réseau.

Un relais selon l'invention est typiquement du type Half Duplex.

Selon un mode de réalisation particulier, un procédé de transmission comprend en outre une étape de mise en forme d'un signal de contrôle indiquant les messages détectés sans erreur représentés dans le signal représentatif destiné au récepteur du signal.

Un tel message permet de simplifier notablement le traitement à la réception.

Selon un mode de réalisation particulier, un procédé de transmission est tel que le codage canal est de type systématique.

Un tel type de codage permet de pouvoir très aisément poinçonner la partie systématique du code et de transmettre par le relais que la partie parité ce qui optimise l'efficacité spectrale de la transmission relais vers destination.

Selon un mode de réalisation particulier, le codage canal est binaire et le procédé de transmission comprend en outre :

- une étape de conversion binaire à symbole entre l'étape d'entrelacement et l'étape de codage réseau algébrique et
- une étape de conversion symbole à binaire après l'étape de codage réseau algébrique.

Ce mode est particulièrement adapté à un codage canal source binaire.

Selon un mode de réalisation particulier, un procédé de transmission est tel que le corps fini d'ordre strictement supérieur à deux est le corps de Galois d'ordre quatre.

L'ordre quatre du corps correspond au choix optimal pour un nombre M de relais allant jusqu'à trois.

Selon un mode de réalisation particulier, un procédé de transmission est tel que l'étape de détection d'erreurs est effectuée au moyen de l'exploitation d'une information de redondance de type cyclique associée à un message transmis par une source.

Ce mode a pour avantage d'être particulièrement simple à mettre en œuvre. Il est adapté à un encodage à la source de type systématique.

Selon un mode de réalisation particulier, un procédé de transmission est tel que l'étape de détection/décodage conjoint itératif effectue conjointement une détection multi utilisateurs et un décodage à entrées souples et sorties souples.

Ce mode a pour avantage d'être plus performant qu'une détection multi utilisateurs suivie d'un décodage sans échange d'informations a priori entre les deux.

Selon un mode de réalisation particulier, un procédé de transmission est tel que l'étape de détection/décodage conjoint itératif met en œuvre un décodage espace temps.

Ce mode est particulièrement adapté à un système dans lequel les sources sont équipées de plusieurs antennes d'émission et effectuent un codage espace temps. Dans le cas où les relais sont équipés de plusieurs antennes de réception, le système est dit MIMO sinon il est dit MISO.

Selon un mode de réalisation particulier, un procédé de transmission est tel que l'étape de mise en forme comprend une modulation des messages avant émission et un entrelacement entre le codage canal et la modulation.

Ce mode permet une grande flexibilité dans la construction du schéma de modulation et codage en autorisant un choix indépendant de la modulation et du codage. En outre, l'entrelaceur canal permet un procédé itératif entre détection et décodage à la destination et au relais.

Selon un mode de réalisation particulier, un procédé de transmission met en œuvre un turbo code distribué entre les sources et le relais. En outre, l'étape de codage dans les sources met en œuvre un codeur convolutif.

Par exemple, le turbo code distribué est constitué, à une source, d'un code convolutif RSCC de rendement 1/2, et aux relais d'un RSCC de rendement 2/3 précédé d'un entrelaceur pour chaque flux issu du décodeur. Le choix d'un turbo code distribué avec concaténation parallèle permet une mise en œuvre très simple d'un codage de réseau spatialement distribué pour un système MS-MR semi-orthogonal avec un relais half-duplex en ayant par construction un code composé d'une concaténation d'une partie systématique et de deux parties redondances (une première partie redondance déterminée et émise par source et une seconde partie redondance déterminée et émise par les relais). Cette concaténation permet d'émettre par une des sources pendant le premier intervalle de transmission la partie systématique et la première partie redondance et d'émettre par les relais pendant le second intervalle de transmission la deuxième partie redondance. Cette concaténation permet donc simplement d'obtenir que les relais fournissent une nouvelle information de redondance aux bits d'information correspondant à la partie systématique indépendamment de la première partie redondance transmise pendant le premier intervalle de transmission des sources à la destination. La destination dispose donc de plusieurs redondances ce qui permet un décodage très puissant et donc une amélioration de la fiabilité.

L'invention a en outre pour objet un procédé de réception destiné à un récepteur d'un système MS-MR semi-orthogonal destiné à mettre en œuvre un procédé de transmission selon l'invention. Le procédé de réception comprenant de manière itérative :

- une première étape de détection multi utilisateurs de messages codés émis simultanément respectivement par les sources pour obtenir des informations souples sur les messages codés respectivement par les sources,
- une seconde étape de détection multi utilisateurs de messages codés émis simultanément respectivement par les relais pour obtenir des informations souples sur les messages codés par les relais,
- une première étape de N décodages canal souple en parallèle des messages codés respectivement par les N sources et
- une seconde étape de M décodages réseau souples algébriques en cascade des messages codés respectivement par les M relais sous contrôle d'une information sur les messages détectés sans erreur par les relais,

la première étape de N décodages canal souple utilise comme informations a priori les informations souples provenant de la première étape de détection pour fournir des informations souples sur les messages décodés à la seconde étape de M décodages réseau souples algébriques,
la seconde étape de M décodages réseau souples utilise comme informations a priori les informations souples provenant de la première et seconde étape de détection pour fournir en retour à la seconde étape de détection des informations souples sur les messages décodés,
la première étape de N décodages canal souple et la seconde étape de M décodages réseau souples se fournissant mutuellement des informations extrinsèques, la fourniture mutuelle étant sous contrôle d'une information provenant des relais identifiant les messages détectés sans erreur par les relais.

L'invention a en outre pour objet un récepteur destiné à un système MS-MR semi-orthogonal destiné à mettre en œuvre un procédé de transmission selon l'invention. Le récepteur comprend :

- un premier moyen de détection conjointe multi utilisateurs pour séparer les flux simultanés de messages codés provenant respectivement des N sources pendant une 1ère phase de transmission et pour générer des informations souples sur les messages codés,

- un second moyen de détection conjointe multi utilisateurs pour séparer les flux simultanés de messages codés provenant respectivement des M relais pendant une 2nde phase de transmission et pour générer des informations souples sur les messages codés provenant respectivement des relais,
- autant de décodeurs souples en parallèle que de sources pour décoder de manière souple les messages codés respectivement par les sources en utilisant comme informations a priori les informations souples provenant du premier moyen de détection et pour générer des informations souples sur les messages décodés,
- autant de décodeurs algébriques souples fonctionnant en cascade que de relais pour décoder de manière souple les messages codés respectivement par les relais en utilisant comme informations a priori les informations souples provenant des premier et second moyens de détection et pour fournir en retour au second moyen de détection des informations souples sur les messages décodés,
les N décodeurs canal souples et les M décodeurs algébriques souples se fournissant mutuellement des informations extrinsèques, la fourniture mutuelle étant sous contrôle d'une information provenant des relais identifiant les messages détectés sans erreur par les relais,
- un moyen de prise de décision des décodeurs canal pour obtenir une estimation des messages provenant respectivement des sources.

Ce procédé de réception et ce récepteur ont pour avantage d'être adaptés à un système MS-MR semi-orthogonal mettant en œuvre un procédé de transmission selon l'invention.

Les différents modes de réalisation précédents peuvent être combinés ou pas avec un ou plusieurs de ces modes pour définir un autre mode de réalisation.

L'invention a en outre pour objet un système MS-MR semi-orthogonal, éventuellement MIMO, adapté pour la mise en œuvre d'un procédé selon l'invention.

Ainsi, un système MS-MR semi-orthogonal selon l'invention, comprend au moins deux relais selon l'invention.

Selon une implémentation préférée, les étapes du procédé de transmission, respectivement de réception, sont déterminées par les instructions d'un programme de transmission, respectivement de réception, incorporé dans un ou plusieurs circuits électronique telle des puces elle-même pouvant être disposées dans des dispositifs électroniques du système MS-MR semi-orthogonal. Le procédé de transmission, respectivement de réception, selon l'invention peut tout aussi bien être mis en œuvre lorsque ce programme est chargé dans un organe de calcul tel un processeur ou équivalent dont le fonctionnement est alors commandé par l'exécution du programme.

En conséquence, l'invention s'applique également à un programme d'ordinateur, notamment un programme d'ordinateur sur ou dans un support d'informations, adapté à mettre en œuvre l'invention. Ce programme peut utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter un procédé selon l'invention.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une clé USB ou un disque dur.

Alternativement, le support d'informations peut être un circuit intégré dans lequel le programme est incorporé, le circuit étant adapté pour exécuter ou pour être utilisé dans l'exécution du procédé en question.

D'autre part, le programme peut être traduit en une forme transmissible telle qu'un signal électrique ou optique, qui peut être acheminé via un câble électrique ou optique, par radio ou par d'autres moyens. Le programme selon l'invention peut être en particulier téléchargé sur un réseau de type Internet.

## Liste des figures

D'autres caractéristiques et avantages de l'invention apparaîtront plus clairement à la lecture de la description suivante de modes de réalisation préférentiels, donnés à titre de simples exemples illustratifs et non limitatifs, et des dessins annexés, parmi lesquels :

- la figure 1 est un exemple d'un système MS-MR de l'art antérieur avec des liens orthogonaux entre les différents nœuds,
- la figure 2 est un schéma illustrant la topologie des systèmes MS-MR ayant N sources $S_1,...S_N$ et M relais $R_1, ..., R_N$ pour un récepteur D,
- la figure 3a est un schéma d'un système MS-MR semi-orthogonal selon l'invention tel que les liens sont non orthogonaux entre les sources et les relais, entre les sources et la destination, sur laquelle est représentée la 1ère phase de transmission,

...

- la figure 3b est un schéma d'un système MS-MR semi-orthogonal selon l'invention tel que les liens sont non orthogonaux entre les relais et la destination, sur laquelle est représentée la 2$^{nde}$ phase de transmission,
- la figure 4 est un organigramme simplifié du procédé de transmission selon l'invention mis en œuvre par un système MS-MR semi-orthogonal illustré par la figure 3,
- la figure 5 est un schéma d'un premier mode de réalisation d'un système MS-MR selon l'invention dans lequel les schémas de codage et modulation spatio-temporels aux sources et aux relais sont définis dans le corps binaire,
- la figure 6 est un schéma d'un détecteur/décodeur conjoint itératif JDDj qui effectue la détection et le décodage conjoint des messages transmis simultanément par les sources reçus par le relais,
- la figure 7 est un schéma d'un détecteur conjoint MAPD-E,
- la figure 8 est un schéma d'un décodeur DecS$_i$,
- la figure 9 est un schéma d'un second mode de réalisation d'un système MS-MR selon l'invention dans lequel les schémas de codage et modulation spatio-temporels aux sources et aux relais sont définis dans le corps défini par le codage réseau algébrique,
- la figure 10 est un schéma d'un récepteur à la destination selon l'invention,
- la figure 11 est un schéma d'un exemple de réalisation du décodeur SISO Algj dans le cas où toutes les transmissions se font dans le corps $F_4$ c'est-à-dire selon le second mode illustré par la figure 9 pour lequel le codage canal est de type algébrique,
- la figure 12 est un schéma d'un exemple de réalisation du décodeur SISO Alg dans le cas d'un codage canal binaire, c'est-à-dire selon le premier mode illustré par la figure 5,
- les figures 13-15 sont des schémas illustrant la structure adaptative du récepteur en fonction de l'information « inband » transmises par les relais.

## Description de modes de réalisation particuliers

Les notations suivantes sont utilisées dans la demande.

Tous les vecteurs utilisent des caractères **gras.** Un vecteur v a son k$^{ième}$ élément noté [**v**]$_k$ ou v$_k$.

$F_q$ est le corps de Galois à q éléments, $\mathbb{R}$ le corps des réels et $\mathbb{C}$ le corps des complexes.

Les matrices/tenseurs utilisent des majuscules en caractères **gras.** Soit **X** une matrice de dimension $N \times M$ appartenant au corps E, c'est-à-dire $\mathbf{X} \in E^{N \times M}$, **x**$_k$ dénote sa k$^{ième}$ colonne (k=1 ,...,M).

Les fonctions utilisent des caractères majuscules non-italiques. Une fonction multidimensionnelle F s'applique en entrée sur une matrice **A** de dimension $m \times q$ où chaque élément a$_{i,j}$ (pour tout i=1, ..,m et j=1,..,q) appartient à l'ensemble E et détermine une matrice **B** de dimension $n \times p$ dont chaque élément b$_{i,j}$ (pour tout i=l, ..., n et j=1, ...,p) appartient à l'ensemble G, telle que F(**A**) = **B** dénotée : $F : E^{m \times q} \rightarrow G^{n \times p}$.

La densité de probabilité d'une variable aléatoire complexe **x** qui suit une distribution gaussienne à symétrie circulaire de moyenne $\mu_x$ et de covariance $\sigma_x^2$ est notée : $CN(\mu_x, \sigma_x^2)$.

Une transmission selon l'invention est mise en œuvre dans des systèmes MS-MR dont la topologie est illustrée par la figure 2. Cette topologie est telle que les sources, nœuds $S_i$, $i \in \{1,..., N\}$, diffusent leurs séquences d'informations codées à l'attention des relais $R_j$, $j \in \{1...,M\}$ et du destinataire D; les sources sont typiquement des terminaux d'utilisateurs qui cherchent à joindre une même station de base en s'aidant de relais. Chaque relais décode les signaux reçus issus des sources, $S_1$ à $S_N$, et ré-encode conjointement les séquences issues du décodage en ajoutant une redondance propre créant un code de réseau. A la destination D, le décodage des séquences codées spatialement distribuées, comprenant les séquences codées reçues issues directement des N sources et les séquences codées issues des M relais, repose sur des algorithmes de décodage canal et de décodage réseau.

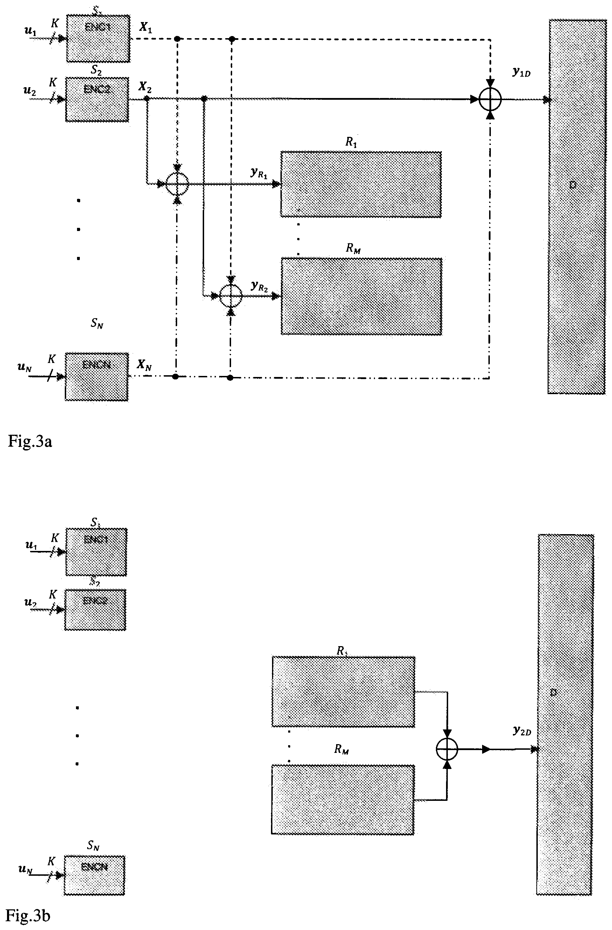

L'invention utilise des relais selon un nouveau protocole de transmission semi-orthogonal illustré par les figures 3a et 3b, pour améliorer l'efficacité spectrale de la transmission tout en permettant un décodage simple et efficace à la destination. La figure 3a représente la 1$^{ère}$ phase de transmission pendant laquelle seules les sources émettent simultanément à destination des relais et de la destination. Pendant cette phase les relais se taisent. La figure 3b représente la 2$^{nde}$ phase de transmission pendant laquelle les sources se taisent et les relais émettent simultanément à destination de la destination.

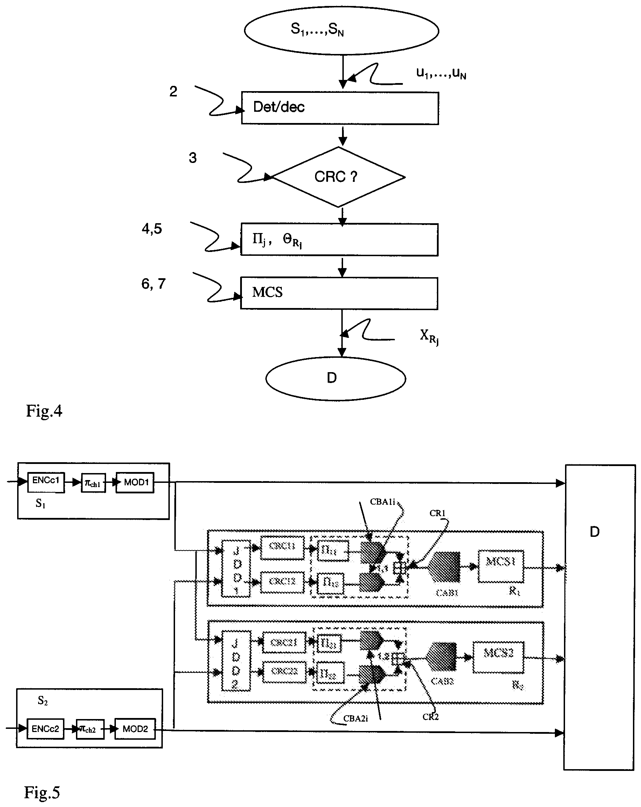

Ainsi, un procédé 1 selon l'invention est illustré par la figure 4.

Il n'y a aucune contrainte sur le canal de transmission ; il peut être à évanouissement rapide (fast fading), les coefficients des matrices représentant le canal de transmission changent à chaque utilisation de canal, ou lent (slow B-block fading), les coefficients restent constant sur N/B utilisations de canal consécutives (bloc) mais changent d'un bloc à l'autre, il peut être sélectif en fréquence, et il peut être MIMO. Les notations adoptées dans la description qui suit correspondent au cas d'un canal « slow 1-block fading » ou quasi statique.

Dans la suite de la description, les nœuds (sources, relais, et destination) sont supposés parfaitement synchronisés et les sources sont indépendantes (il n'y a pas de corrélation entre elles).

Le protocole de transmission semi-orthogonal est tel que la transmission de l'information vers la destination se déroule sur $N_{use}$ utilisations du canal réparties en deux phases : dans une 1ère phase les sources transmettent pendant $\alpha N_{use} = Ch_{use}$ utilisations du canal, dans une 2nd phase les relais transmettent pendant $(1 - \alpha)N_{use} = Ch_{useR}$ utilisations du canal.

Selon un premier aspect de l'invention, le procédé 1 de transmission semi orthogonal d'un signal est mis en œuvre par les relais $\boldsymbol{R_j}$ du système.

Un bloc $u_i \in F_q^K \ i \in \left\{1, \ldots, N\right\}$ de données source est un vecteur message de longueur $K$ dont les composantes prennent leurs valeurs dans un corps $\boldsymbol{F_q}$ finis d'ordre q entier.

Les sources $S_i$ statistiquement indépendantes effectuent un codage canal des données d'information $\mathbf{u}_i$ en ajoutant à une partie systématique une redondance cyclique ou CRC (Cyclic Redundancy Check) qui permet de vérifier l'intégrité du message. Les sources $S_i$ équipées de $T_{S_i}$ antennes d'émission utilisent un schéma de modulation et codage espace-temps $\Theta_i$ défini sur $F_q$ (par exemple, le corps des binaires $F_2$ ou le corps fini à quatre éléments $F_4$) qui associe à tout bloc $\boldsymbol{u_i}$ des symboles codés et modulés $\mathbf{X}_i \in \chi_i^{T_{S_i} \times Ch_{use}}$ appartenant aux constellations complexes $\chi_i$ de cardinalités $|\chi_i| = 2^{w_i}$, $w_i \in \mathbb{N}$. Un symbole de $F_q$ a une représentation binaire contenant $\ln_2(q)$ bits. Si le rapport

$$s_i = \frac{w_i}{\ln_2\left(q\right)}$$ est entier, il représente le nombre de symbole(s) de $F_q$ portés par la modulation. La fonction $\Theta_i$ peut

être décrite de la façon générique suivante : $\Theta_i : F_q^K \ \rightarrow \ \chi_i^{T_{S_i} \times Ch_{use}}$. Le codage canal et le codage espace temps sont mis en œuvre par les codeurs ENCi.

Lors de la première phase de transmission, les sources émettent les N symboles $\mathbf{X}_i$.

Chaque relai $\boldsymbol{R_j}$ est équipé de $N_{R_j}$ antennes de réception et de $T_{R_j}$ antennes d'émission. Chaque relai reçoit lors de la première phase de transmission les versions perturbées des N signaux sources transmis par les canaux sources-relais. Le canal entre les sources $S_i$ et un relai $R_j$ est désigné par l'ensemble des coefficients du canal

MIMO : $\left\{H_{S_i R_j,k,m} \in C^{N_{R_j} \times T_{S_i}}\right\}$. Le signal reçu à l'instant k par le relai $\boldsymbol{R_j}$ s'exprime sous la forme suivante :

$$y_{R_j,k} = \sum_{i=1}^{N}\sum_{m=0}^{L_m} H_{S_i R_j,k,m} X_{i,k-m} + n_{R_j,k}, \ k \in \{1,..,Ch_{use}\} \text{ où } \quad n_{R_j,k} \in C^{N_{R_j}}$$

désigne le vecteur de bruit additif au niveau du relai $\boldsymbol{R_j}$ à l'instant k et $L_m$ désigne la mémoire du canal. L'effet mémoire du canal est lié au retard de propagation (delay-spread selon la terminologie anglo saxonne). Ce retard entraîne une superposition des signaux transmis ce qui se traduit par de l'interférence entre symboles.

La destination dispose de $N_D$ antennes de réception. La destination reçoit lors de la première phase de transmission les versions perturbées des N signaux sources transmis par les canaux sources-destination. Soient $H_{S_i D} \in \mathbb{C}^{N_D \times T_{S_i}}$ les matrices des coefficients de fading associées aux N canaux Source-Destination. Le signal reçu par la destination lors de la première phase de transmission s'écrit :

$$y_{1D,k} = \sum_{i=1}^{N} \sum_{m=0}^{L_m} H_{S_i D,k,m} X_{i,k-m} + n_{1D,k} \quad k \in \{1,..,Ch_{use}\}$$

où $n_{1D,k} \in \mathbb{C}^{N_D}$ désigne le vecteur de bruit additif au niveau lors de la première phase de transmission au niveau de la destination à l'instant k.

Chaque relai $\boldsymbol{R_j}$ comprend un détecteur/décodeur conjoint itératif d'utilisateurs multiples (« turbo Multiuser détection » ou « turbo-MUD » selon la terminologie anglosaxonne) qui effectue une détection et un décodage 2 conjoint de manière itérative des signaux reçus lors de la première phase pour obtenir les vecteurs des signaux estimés de chaque source $\hat{u}_i \in F_q^K$. Ce traitement conjoint repose sur l'observation du signal reçu représentatif de l'ensemble des messages des sources distordus par le canal et sur un décodage à entrée et sortie souple du codage canal de chaque source. Une estimée du message transmis par chaque source est disponible après un certain nombre d'itérations paramétrable.

Le relai $\pmb{R}_j$ détecte 3 ensuite à l'aide de détecteurs CRC, en parallèles, de la partie redondance des messages les erreurs éventuellement survenues sur les messages estimés précédemment. Soit $J_j \subset \{1,.. N\}$ l'ensemble des indices des messages détectés sans erreurs par le relais $\pmb{R}_j$ dont la cardinalité est $J$.

Le relais $R_j$ entrelace 4, en parallèle, uniquement les J messages non erronés $\hat{u}_i, i \in \pmb{J}_j$ avec un même type d'entrelaceur $\pi_j$ de taille K.

Le relais applique 5 une fonction $\Theta_{R_j}$ aux messages entrelacés au moyen d'un codeur réseau ENW pour obtenir le résultat du codage réseau :

$$u_{R_j} = \Theta_{R_j}\left(\left\{\hat{u}_i, i \in J_j\right\}\right) \in F_q^K$$

La fonction $\Theta_{R_j}$ combine linéairement dans un corps fini de dimension strictement supérieure à 2 les messages entrelacés. Cette opération linéaire est appelée codage réseau. Un codage réseau est une combinaison linéaire des N messages des sources reçus par un relais qui peut être représentée par un vecteur de dimension N dont chaque composante est non-nulle. Le codage réseau associé au relais $\pmb{R}_j$ est défini par le vecteur $a_j = [a_{1,j} \; a_{2,j} \; ... \; a_{N,j}]^T$ de dimension N. En supposant que ce relais ne détecte que J messages sans erreur dont les indices sont compris dans l'ensemble $J_j \subset \{1,..N\}$ alors le résultat du codage réseau $u_{R_j}$ est la combinaison linéaire $u_{R,j} = \sum_{i \in J_j} a_{i,j} \hat{u}_i$. Ceci revient à mettre à zéro les coefficients $\left\{a_{i,j}\right\}_{i \notin J_j}$ du vecteur **a** dont les indices ne sont pas inclus dans l'ensemble $J_j$. Ainsi, il est possible de définir un codage réseau effectif pour chaque relais dépendant des messages des sources n'ayant pu être détectés sans erreur. Selon cette définition, la non-transmission d'un relais est un codage réseau effectif consistant en un vecteur nul de dimension N.

Dans un système à M relais, l'ordre de diversité maximal est M+1. Un système comportant N sources et M relais est dit à diversité maximale si, dans le cas où M liens quelconques sont coupés parmi les NM liens S-R et les N+M liens S-D et R-D, il est toujours possible de retrouver les N messages des sources (les messages associés aux liens restants sont supposés détectés sans erreur). Soit $T = [I_N G]$ la matrice génératrice systématique où $I_N$ est la matrice identité de dimension N et G représente les M vecteurs du codage réseau effectif des relais. La détermination des vecteurs $a_j = [a_{1,j} \; a_{2,j} \; ... \; a_{N,j}]^T$ du codage réseau peut se faire en tirant aléatoirement de façon indépendante les composantes des vecteurs après avoir choisi l'ordre du corps strictement supérieur à deux. A l'issu du tirage, il faut vérifier que la diversité maximale est atteinte. Ceci nécessite de considérer toutes les configurations de Q coupures des MN liens S-R, $Q \in \{0,1,..., M\}$, et de s'assurer que la matrice génératrice systématique $T = [I_N G]$ vérifie la condition suivante : après suppression de M-Q colonnes de la matrice $T$, les N+Q restantes ont la propriété d'avoir un rang au moins égal à N. A noter qu'il suffit de tester le cas Q=0 (pas de coupure des MN canaux sources vers destination), la validité des autres conditions s'en déduit mathématiquement.

Les messages codés canal issus des sources et les messages correspondants entrelacés par le relais puis codés réseau par la fonction $\Theta_{R_j}$ forme un turbo code distribué. L'entrelacement permet à la destination de mettre en œuvre un décodage canal/réseau conjoint itératif basé sur les signaux reçus depuis les sources et les relais. Dans le cas ou J=I, l'opération linéaire revient à l'identité.

Le signal résultant du codage réseau est mis en forme 6, 7 par le relais pour obtenir le signal : $\mathbf{X}_{R_j} \in \mathbb{C}^{T_{R_j} \times Ch_{useR}}$. La mise en forme comprend typiquement une opération de modulation et codage spatio-temporel. Le signal mis en forme $\mathbf{X}_{R_j} \in \mathbb{C}^{T_{R_j} \times Ch_{useR}}$ est transmis à partir des antennes du relais. Le relais $\pmb{R}_j$ signale à la destination D les J messages participant au codage réseau au moyen d'un signal de contrôle dit dans la bande ("in-band"), par exemple consistant en des bits de contrôle. De manière alternative, le relais peut signaler les messages détectés avec erreur.

Durant la seconde phase du protocole semi-orthogonal, les relais émettent simultanément pendant le même nombre d'utilisations $Ch_{useR}$ du canal sur la même ressource radio et les sources se taisent. Les signaux $\pmb{X}_{R_j}$ émis

simultanément par les relais interférent à la destination. Soient $H_{R_jD} \in \mathbb{C}^{N_D \times T_{R_j}}$ les matrices des coefficients des M canaux Relai-Destination. Le signal reçu à la destination durant la seconde phase s'écrit :

$$y_{2D,k} = \sum_{j=1}^{M} \sum_{m=0}^{L_m} H_{R_jD,k,m} X_{R_j,k-m} + n_{2D,k} \qquad k \in \{1,..,Ch_{useR}\},$$

où $n_{2D,k} \in \mathbb{C}^{N_D}$ est le bruit additif pendant la 2$^{nde}$ phase de transmission au niveau de la destination à l'instant k.

Le destinataire observe une superposition des symboles émis par les sources pendant la 1$^{ère}$ phase de transmission puis des symboles émis par les relais pendant la 2$^{nde}$ phase. La destination dispose à l'issue de la 2$^{nde}$ phase de transmission des signaux provenant directement des sources et des signaux provenant des relais. La destination peut procéder à un décodage conjoint canal réseau afin de retrouver les signaux sources : $u_1 ... u_N$ à partir des signaux reçus.

Les schémas de codage et modulation spatio-temporels aux sources et aux relais sont définis, soit dans le corps binaire, soit dans le corps défini par le codage réseau, c'est-à-dire que leur décodage fourni une information probabiliste sur la représentation des messages des sources soit dans le corps binaire soit dans le corps associé au codage réseau.

La description de l'invention est détaillée à l'appui d'exemples de réalisation particulier de systèmes MS-MR semi orthogonaux comprenant deux sources et deux relais. Chaque source a une antenne d'émission, chaque relais a une antenne de réception et une antenne d'émission et la destination a une antenne de réception.

Selon un premier mode de réalisation de l'invention, les schémas de codage canal et modulation aux sources et aux relais sont définis dans le corps binaire. Un exemple de réalisation est illustré par la figure 5. Les schémas de modulation et codage aux sources et aux relais sont basés sur un schéma de type « Bit Interleaved Coded Modulation » (BICM) qui correspond à la concaténation d'un codage canal binaire (défini dans le corps binaire), d'un entrelaceur binaire, et d'un codage bit à symbole (modulateur) de Gray. Le codage canal est de préférence de type systématique, par exemple les encodeurs sont basés sur des codes convolutifs récursifs systématiques RSC éventuellement associé à un poinçonnage.

Les sources Si, i=1 ou 2, comprennent un encodeur ENCci pour effectuer le codage canal des messages à transmettre. Un message $u_i \in F_2^K$ est codé en un vecteur $c_i \in F_2^{n_i}$ où $\frac{n_i}{K}$ est le rendement de l'encodeur associé à la source $S_i$. Les mots de code $c_i$ sont entrelacées avec un entrelaceur binaire $\pi_{chi}$. L'entrelaceur est nécessaire pour assurer l'indépendance entre les valeurs codées en diminuant la corrélation entre les valeurs codées successives. La sortie de l'entrelaceur correspond aux matrices $V_i \in F_2^{Ch_{use} \times S_i}$. Les mots entrelacés sont modulés par un modulateur MODi en des séquences $x_i \in \mathbb{C}^{Ch_{use}}$ avec $2^{S_i}$ l'ordre de la modulation ; l'étiquetage se fait par la fonction bijective suivante : $\phi_i : F_2^{S_i} \rightarrow \mathcal{X}_i$. Soit $v_{i,k,l} = \phi_{i,l}^{-1}(x_{i,k})$ le $l^{ème}$ bit correspondant au symbole modulé $x_{i,k}$ (correspondant aux bits de la source i $\{v_{i,k,i} : l = 1,\cdots,s_i\}$).

Le relais $R_j$, j=1 ou 2, comprend un détecteur/décodeur conjoint itératif JDDj (abréviation de Joint Detector and Decoder ou Turbo MUD) avec autant de sorties que de sources $S_i$, un détecteur d'erreur CRC$_{ji}$ sur chaque sortie du détecteur/décodeur conjoint, un entrelaceur $\pi_{ji}$ après chaque détecteur d'erreur CRC$_{ji}$, un codeur réseau algébrique CR$_j$ connecté aux sorties des entrelaceurs $\pi_{ji}$ et un module de mise en forme MCSj en sortie du codeur réseau algébrique. Selon ce mode, les relais comprennent en outre autant de convertisseurs binaire-algébrique CBAji en entrée du codage réseau qu'il y a de sources ainsi qu'un convertisseur algébrique-binaire CABj en sortie du codage réseau.

Le détecteur/décodeur conjoint itératif JDDj effectue la détection et le décodage conjoint des messages transmis simultanément par les sources. Il est illustré par la figure 6. Il comprend un détecteur conjoint MAPD-E, deux décodeurs DecS$_1$, DecS$_2$ correspondant à chacune des sources, deux entrelaceurs $\pi_{ch1}$, $\pi_{ch2}$ entre les sorties des décodeurs et les entrées du détecteur et deux desentrelaceurs $\pi_{ch1}^{-1}$, $\pi_{ch2}^{-1}$ entre les sorties du détecteur et les entrées des décodeurs. Les entrelaceurs sont de même type que ceux utilisés aux niveaux des sources. Les desentrelaceurs sont inverses des entrelaceurs. Le relai $R_j$ reçoit un signal $y_{R_j,k}$ résultant de l'interférence des signaux des deux sources S$_i$ :

$$y_{R_j,k} = h_{1R_j} x_{1,k} + h_{2R_j} x_{2,k} + n_{R_j,k} \quad , \qquad k \in \{1,..,Ch_{use}\}$$

où $n_{Rj,k}$ désigne le bruit additif avec la distribution $CN(0, \sigma_n^2)$ et $h_{i,Rj}$ désigne le coefficient du canal entre la source $S_i$ et le relai $R_j$. Le détecteur conjoint MAPD-E (ou MUD (Multi Users Detector)) basé sur le critère Maximum A Posteriori reçoit le signal $y_{Rj,k}$ et échange des informations avec les décodeurs $DecS_1$, $DecS_2$ pour extraire les informations $\hat{u}_1$, $\hat{u}_2$ de chaque source. L'échange porte sur les bits détectés et sur les bits décodés. A chaque itération, les décodeurs reçoivent en entrée des rapports logarithmiques de probabilités intrinsèques des bits codés $\{L(c_i)\}$ et fournissent des LLR extrinsèques $\{E(c_i)\}$ sur les bits codés $c_i$. Les LLR extrinsèques après ré-entrelacement $\{E(V_i)\}$ sont assimilés à des LLR a priori aux entrées du détecteur. Les itérations s'arrêtent lorsque les messages sont parfaitement décodés ou après un certain nombre d'itérations paramétrable.

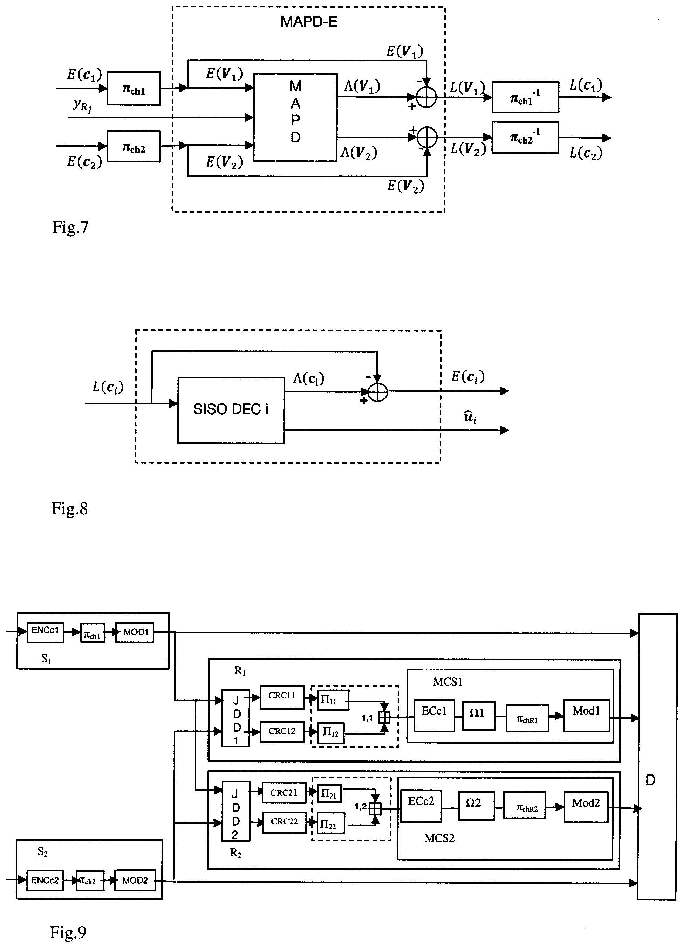

Le détecteur conjoint MAPD-E est illustré par la figure 7. Le détecteur multi utilisateurs met en œuvre les équations suivantes :

$$\Lambda\left(v_{i,k,l}\right) = \log\left(\frac{P\left(v_{i,k,l} = 1 \,\middle|\, y_{R_j}\right)}{P\left(v_{i,k,l} = 0 \,\middle|\, y_{R_j}\right)}\right)$$

$$\approx \log \frac{\sum_{a \in \chi_i : \phi_{i,l}^{-1}(a)=1, b \in \chi_j} P\left(Y_{R_j} \,\middle|\, x_{i,k} = a, x_{j,k} = b\right) e^{\xi(a) + \xi(b)}}{\sum_{a \in \chi_i : \phi_{i,l}^{-1}(a)=0, b \in \chi_j} P\left(Y_{R_j} \,\middle|\, x_{i,k} = a, x_{j,k} = b\right) e^{\xi(a) + \xi(b)}}$$

où $(i,j) \in \{1,2\}^2$ tels que $i \neq j$ et :

$$\begin{cases} \xi(a) = \displaystyle\sum_{l'=1}^{\log_2(|\chi_i|)} \phi_{i,l}^{-1}(a)\ E\left(v_{i,k,l'}\right) \\ \xi(b) = \displaystyle\sum_{l'=1}^{\log_2(|\chi_j|)} \phi_{j,l}^{-1}(b)\ E\left(v_{j,k,l'}\right) \end{cases}$$

et où $E(v_{i,k,l'})$ est l'information extrinsèque du bit $v_{i,k,l'}$ fournie par le décodeur correspondant à la source $S_i$, le $l$'ème bit dans l'étiquetage correspondant au symbole $x_{i,k}$.

Les sorties du détecteur conjoint sont alors décrites par : $L(V_i) = \Lambda(V_i) - E(V_i)$ où $\Lambda(V_i)$ est le LAPPR sur le bit $V_i$ et $E(V_i)$ est l'information extrinsèque issue du décodeur associé à la source $S_i$ de ce bit.

Le décodeur $DecS_i$ est illustré par la figure 8. Il s'agit d'un décodeur à entrées souples et sorties souples, par exemple du type BCJR [2]. Les équations qui caractérisent l'échange d'informations souples au niveau du décodeur sont données par :

$$E(c_i) = \Lambda(c_i) - L(c_i)$$

où $\Lambda(c_i)$ est le LLR correspondant au bit codé du mot de code $c_i$, $L(c_i)$ est l'information à priori sur ce bit et $E(c_i)$ qui est fournie au détecteur, est l'information extrinsèque sur ce bit codé.

Le détecteur d'erreur $CRCji$ détecte les erreurs pour ne sélectionner que les messages décodés sans erreur. Dans le cas d'un codage systématique aux sources, le contenu des messages sans erreur sélectionnés correspond aux bits systématiques des mots de code détectés sans erreur.

Les entrelaceurs $\pi_{ji}$ sont définis dans le corps binaire, ils sont identiques pour un relais donné compte tenu que le procédé met en œuvre un codage conjoint canal-réseau. L'entrelaceurs $\pi_{ji}$ entrelace les messages détectés sans erreur de la source $S_i$ correspondant aux bits systématiques de leurs mots de code respectifs, ce qui permet de créer un Turbo code distribué.

Les convertisseurs binaire-algébrique $CBAji$ associent un nombre $n = \ln_2(q)$ de bits (q est une puissance de 2 égale à la cardinalité du corps, $\ln_2$ est le logarithme base 2) à un élément du corps défini par le codage réseau. Ainsi, dans l'exemple du corps de Galois à quatre éléments $F_4$, les convertisseurs s'appuient sur la fonction bijective s suivante :

$$s : \left\{0,1\right\} \times \left\{0,1\right\} \to F_4$$

qui associe à deux bits $(b_1,b_2)$ le symbole $q = s(b_1,b_2)$ de $F_4$.

Cette fonction et son inverse donne la représentation binaire d'un élément de $F_4$. Nous noterons par la suite

$b_1 = s_1^{-1}(q)$ et $b_2 = s_2^{-1}(q)$ pour $q = s(b_1,b_2)$.

Le codeur réseau $CR_j$ représenté par un carré rempli d'une croix sur la figure 5 effectue la combinaison linéaire dans le corps $F_4$ des messages des deux sources détectés sans erreur, entrelacés et convertis sous forme algébrique. Les vecteurs du codage réseau des relais $R_1$ et $R_2$ sont respectivement $[1,1]^T$ et $[1,2]^T$. Le codage réseau $[n,m]^T$ défini par les vecteurs $[1,1]^T$ et $[1,2]^T$ réalise l'opération $n.u_1+m.u_2$. Le système formé par les équations indépendantes $u_2+u_1$ et u1+2.u2 est inversible dans $F_4$ et permet donc de remonter aux messages u1 et u2 en cas de coupure des liens S1-D et S2-D.

Les convertisseurs algébrique-binaire transforment un élément du corps fini en sa représentation binaire, ils mettent en œuvre la fonction inverse de s.

Le module de mise en forme MCSj met en œuvre un schéma de codage et modulation qui est par exemple de type BICM (abréviation de Bit Interleaving Coding and Modulation) qui correspond à la concaténation d'un codage canal binaire (défini dans le corps binaire), d'un entrelaceur binaire et d'un codage bit à symbole (modulateur) de Gray. Le codage canal binaire aux relais est basé par exemple sur des codes récursifs systématiques (RSC). Le vecteur des bits codés est noté : $c_{R_j} \in F_2^{n_{R_j}}$.

Selon une réalisation particulière, le codage canal est suivi d'une opération de poinçonnage $\Omega$ qui consiste à ne garder que les bits de parité déterminés par le codeur récursif systématique. Dans ce cas, le rendement globale est égal à $\dfrac{n_{R_j}}{K}$.

Les séquences codées et entrelacées sont notées : $V_{R_j} \in F_2^{Ch_{use_R} \times s_{R_j}}$. Le codage bit à symbole est décrit par $\phi_j^R : F_2^{s_{R_j}} \to \mathcal{X}_j^R$, où $\mathcal{X}_j^R$ dénote la constellation des symboles obtenus avec $2^{s_{R_j}}$ l'ordre de la modulation.

Le signal émis par le relai $R_j$ est dénoté : $x_{R_j} \in \mathbb{C}^{Ch_{use_R}}$.

Dans le cas où les relais ont plusieurs antennes d'émission, la mise en forme est par exemple de type ST-BICM (abréviation de Space Time Bit Interleaving Coding and Modulation).

Selon un second mode de réalisation de l'invention, les schémas de codage et modulation spatio-temporels aux sources et aux relais sont définis dans le corps défini par le codage réseau. Un exemple de réalisation particulier est illustré par la figure 9. Selon ce second mode, les schémas de codage et modulation mis en œuvre aux sources et aux relais sont définis directement sur le corps défini par le codage réseau, c'est-à-dire sur une représentation des messages des sources dans ce corps. L'exemple illustré par la figure 9 est identique à celui de la figure 5 sauf en ce que les relais ne comprennent pas de convertisseur binaire-algébrique, ni algébrique-binaire et en ce que le module de mise en forme MCSj représenté correspond à une réalisation particulière faisant intervenir un poinçonnage $\Omega j$.

Les schémas de modulation et codage sont basés sur un schéma de type « symbole Interleaved Coded Modulation » (SICM) qui correspond à la concaténation d'un codage canal ECcj défini dans le corps $F_4$, d'un entrelaceur symbolique $\pi_{chRj}$ (non binaire) défini sur $F_4$ et d'un modulateur Modj effectuant un codage bit à symbole de Gray fonctionnant sur la représentation binaire des symboles de $F_4$. L'exemple est décrit dans le cas où $s_i = \dfrac{w_i}{\ln_2(q)}$ est un nombre entier. Ainsi un symbole modulé de la source i porte $s_i$ symboles du corps considéré, i.e. les modulateurs peuvent être considérés comme des fonctions bijectives $\phi_i : F_4^{s_i} \to \mathcal{X}_i$.

La détection et le décodage effectués par le relais se déroulent de manière similaire à ce qui a été décrit pour l'exemple correspondant au mode binaire illustré par les figures 5-8. La différence vient du fait que les informations échangées entre le détecteur et les décodeurs sont désormais des vecteurs. La linéarité des opérations de détection et de décodage fait qu'il est équivalent d'appliquer sur chaque composante de ces vecteurs les mêmes opérations que celles décrites dans le cas du mode binaire.

Le détecteur multi utilisateurs met en œuvre les équations suivantes :

$$\Lambda_q\left(v_{i,k,l}\right) = \log\left(\frac{P\left(v_{i,k,l} = q \,|y_{R_j}\right)}{P\left(v_{i,k,l} = 0 \,|y_{R_j}\right)}\right)$$

$$\approx \log\frac{\sum_{a\in\chi_i:\phi_{i,l}^{-1}(a)=q,b\in\chi_j} P\left(Y_{R_j}\Big| x_{i,k} = a, x_{j,k} = b\right) e^{\xi(a)+\xi(b)}}{\sum_{a\in\chi_i:\phi_{i,l}^{-1}(a)=0,b\in\chi_j} P\left(Y_{R_j}\Big| x_{i,k} = a, x_{j,k} = b\right) e^{\xi(a)+\xi(b)}}$$

où $(i,j) \in \{1,2\}^2$ tels que $i\neq j$ et :

$$\begin{cases} \xi(a) = \displaystyle\sum_{l'=1}^{\log_4(|\chi_i|)} \phi_{i,l'}^{-1}(a)E\left(v_{i,k,l'}\right) \\ \xi(b) = \displaystyle\sum_{l'=1}^{\log_4(|\chi_j|)} \phi_{j,l'}^{-1}(b)E\left(v_{j,k,l'}\right) \end{cases}$$

$E(v_{i,k,l'})$ est l'information extrinsèque fournie par le décodeur correspondant à la source $S_i$, du bit $v_{i,k,l'}$ par rapport à la valeur $\phi_{i,l'}^{-1}(b)$ qui est le $l$'ème bit dans l'étiquetage correspondant au symbole $x_{i,k}$. La sortie du détecteur est décrite alors par : $\mathbf{L}(\mathbf{V}_i) = \Lambda(\mathbf{V}_i) - E(\mathbf{V}_i)$ où $\Lambda(\mathbf{V}_i)$ est le LAPPR du mot $\mathbf{V}_i$ et $\mathbf{E}(\mathbf{V}_i)$ est l'information extrinsèque de ce mot issue du décodeur associé à la source $S_i$. Le décodage se déroule de manière similaire au déroulement décrit en regard de la figure 8.

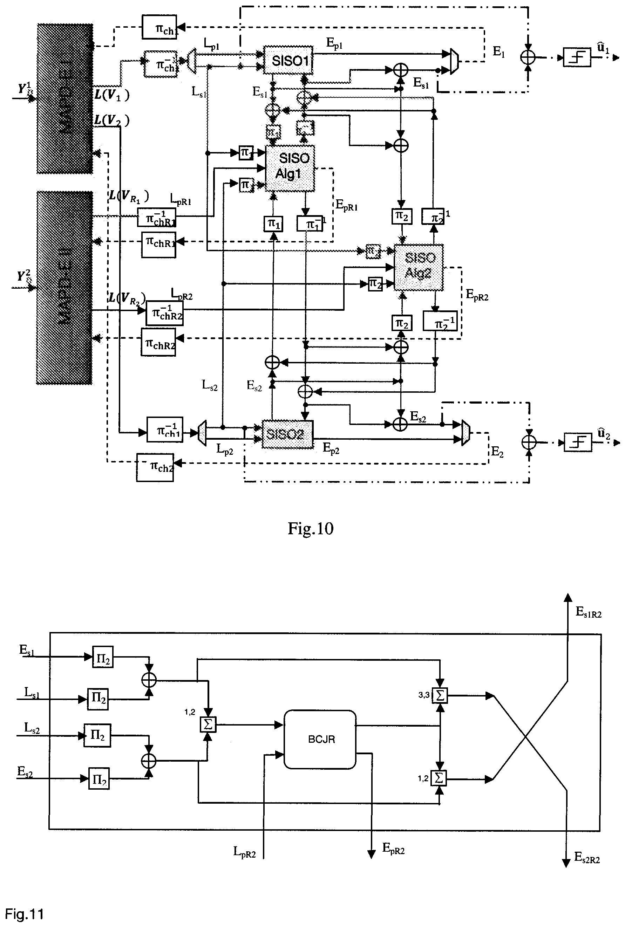

La figure 10 illustre un récepteur à la destination selon l'invention. Il comprend essentiellement deux étages : un étage de détection suivi d'un étage de décodage.

L'étage de détection assure une détection itérative multi utilisateurs pour détecter les messages provenant directement des sources pendant la 1ère phase du protocole et les messages provenant des relais pendant la 2nde phase du protocole au moyen respectivement de deux détecteurs MAPD-EI et MAPD-EII. Les deux détecteurs fournissent des informations souples sur les messages détectés provenant respectivement des sources et des relais.

L'étage de décodage assure le décodage des messages respectivement des sources et des relais à partir des informations souples prises comme a priori provenant de l'étage de détection. Le décodage est effectué au moyen d'autant de décodeurs souples SISO (Soft Input Soft Output) que de sources et d'autant de décodeurs algébriques SISO algj que de codeurs algébriques réseau donc que de relais. Les décodeurs SISO1, SISO2, et les décodeurs SISO Alg1, SISO Alg2 sont basés sur les codes implémentés respectivement aux sources et aux relais.

Les décodeurs souples associés aux sources fonctionnent de manière totalement identique entre eux. Leur fonctionnement est similaire à celui du décodeur décrit en regard de la figure 8. Sur la figure 10, il est représenté un démultiplexeur entre la sortie du détecteur MAPD-EI et chacun des décodeurs souples SISO1, SISO2 qui permet de distinguer la partie systématique et la partie parité du code alors que sur la figure 8 l'entrée unique du décodeur comprend implicitement ces deux parties. Par rapport au décodeur de la figure 8, la différence vient de la prise en compte de l'information de parité fournit par les décodeurs algébriques associés aux relais.

Les décodeurs fournissent des informations souples sur les symboles décodés aux détecteurs. Un échange itératif d'informations souples intervient entre les décodeurs associés aux sources et les décodeurs algébriques associés aux relais qui traduit le décodage conjoint canal réseau itératif.

A chaque itération, les deux détecteurs génèrent des LAPPR sur les bits codés provenant des sources et des relais. Les décodeurs SISO acceptent ces rapports logarithmiques de probabilités intrinsèques des bits codés $L(c_1)$, $L(c_2)$, $L(c_{R_1})$ et $L(c_{R_2})$ et délivrent des rapports logarithmiques de probabilités extrinsèques $E(c_1)$, $E(c_2)$, $E(c_{R_1})$ et $E(c_{R_2})$ sur les bits codés.

Les informations souples des bits systématiques et de parité correspondant à la séquence émise par la source $i$ sont notées $\mathbf{L}_{Si}$ et $\mathbf{L}_{pi}$. Soient $\mathbf{L}_{SiRj}$ les informations souples fournies par le relai $R_j$ pour les bits systématiques de la source $S_i$. Les informations extrinsèques (ou extrinsèques) correspondantes sont notées $E_{Si}$, $E_{pi}$, $\mathbf{E}_{SiRj}$.

Le décodeur SISO Algj est un décodeur à entrées et sorties souples qui intègre une opération logique (algébrique) correspondant à la transformée linéaire du codage réseau du relai $\mathbf{R}_j$ considéré.

La figure 11 est un schéma d'un exemple de réalisation du décodeur SISO Algj dans le cas où toutes les transmissions se font dans le corps $\mathbf{F}_4$ c'est-à-dire selon le second mode illustré par la figure 9 pour lequel le codage canal est de type algébrique. Selon l'exemple illustré, le codage réseau correspond au relais $R_j = R_2$ qui met en œuvre la combinaison linéaire $u_R = u_1 + 2.u_2$. Les messages des sources $u_1$ et $u_2$ représentées dans $F_4$ sont détectés sans erreur au niveau du relais et donc $u_R = u_1 + 2. u_2$ est inclu dans les bits de parité transmis par le relais $R_2$. Le décodeur à entrées et sorties souples SISO Alg2 correspondant au relais considéré reçoit en entrée des informations à priori sur les symboles de parité (du fait du poinçonnage, seuls les bits de parité sont transmis par le relais) du relais $L_{pR}$ ainsi que des informations a priori sur les symboles des deux sources $u_1$ et $u_2$ (incluses dans la partie systématique des mots de codes des sources) qui sont $E'_{S_1} = \Pi\, E_{S_1} + \Pi\, L_{S_1}$ et $E'_{S_2} = \Pi\, E_{S_2} + \Pi\, L_{S_2}$. Ces informations a priori $E'_{S_1}$ et $E'_{S_2}$ sur les symboles des deux sources servent à calculer un a priori sur les symboles systématiques en entrée du codage canal du relais grâce à la relation modélisée par l'operateur $1,2\,\Sigma$ de la figure 11 :

$$E'_{SR,k} = \sum\nolimits_{1,2,k}\left(E'_{S1}, E'_{S2}\right) \text{ où } k \in F_4 = \left\{0,1,2,3\right\}$$

traduisant la relation $u_R = u_1 + 2.u_2$. Soit $E'_{SR}$ l'ensemble $\{E'_{SR'k} : k = 0,1,2,3,4\}$. A partir des vecteurs (à quatre composantes) $E'_{SR}$ et $L_{pR}$ le décodeur fournit en sortie des extrinsèques pour les symboles de parité $E_{pR2}$ du relais $R_2$ considéré et pour les symboles systématiques des deux sources : $E_{SiR2}$ qui sont liées par les relations suivantes modélisées par les opérateurs $1,2\,\Sigma$ et $3,3\,\Sigma$ de la figure 11 :

$$E_{S1R2} = \left(\sum\nolimits_{1,2,k}\left(E_{SR}, E'_{S2}\right)\right)_{k=\left\{0,1,2,3\right\}}$$

traduisant $u_1 = u_R + 2.u_2$ et

$$E_{S2R2} = \left(\sum\nolimits_{3,3,k}\left(E_{SR}, E'_{S1}\right)\right)_{k=\left\{0,1,2,3\right\}}$$

traduisant $u_2 = 3.u_R + 3.u_1$.

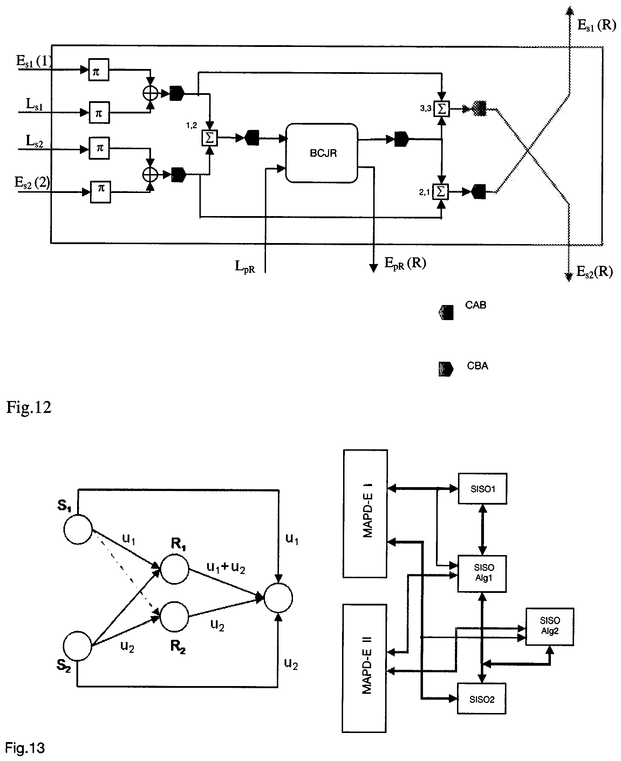

La figure 12 est un schéma d'un exemple de réalisation du décodeur SISO Alg dans le cas d'un codage canal binaire, c'est-à-dire selon le premier mode illustré par la figure 5. Le principe de fonctionnement est le même que celui du décodeur SISO Algj illustré par la figure 11 correspondant à une transmission algébrique et précédemment décrit. La différence vient de l'ajout de convertisseurs binaire/algébrique (bit à symbole) CBAs en entrée des opérateurs $\Sigma$ et de convertisseurs algébrique/binaire (symbole à bit) CABs en sortie des opérateurs $1,2\,\Sigma$ $2,1\Sigma$ et $3,3\Sigma$. Les convertisseurs binaire/algébrique interviennent sur les extrinsèques des sources afin de garder un décodage canal au niveau binaire. Les LLRs et les extrinsèques sont dans le domaine binaire. Soit $u = s(u_1,u_2)$ un élément de $F_4$, soit $q \in F_4$ et soit $\Lambda_q(u) = \log\left(\frac{P(u=q)}{P(u=0)}\right)$ le LLR de u correspondant à la valeur q. Les convertisseurs CBAs bit à symbole effectuent l'opération qui consiste à déterminer le LLR du symbole $u$ connaissant les LLR des bits $\left(u_i\right)_{i\in\left\{1,2\right\}}$

$$\forall\, q \in F_4, \quad \Lambda_q(u) = \sum\nolimits_{i\in\{1,2\}} s_i^{-1}(q)\, \Lambda(u_i) \text{ où } \Lambda(u_i) = \log\left(\frac{P(u_i=1)}{P(u_i=0)}\right).$$

En sortie des opérateurs $1,2\,\Sigma$, $2,1\Sigma$ et $3,3\Sigma$, les convertisseurs CABs symbole à bit effectuent l'opération qui consiste à déterminer les deux LLR associés à chacun des bits composants le symbole $u$ :

$$\Lambda\left(u_i\right) = \log\left(\frac{\sum_{q\in F_4,\, s_i^{-1}(q)=1} e^{\left(\Lambda_q(u)\right)}}{\sum_{q\in F_4,\, s_i^{-1}(q)=0} e^{\left(\Lambda_q(u)\right)}}\right), i \in \left\{1,2\right\}$$

Le décodeur illustré correspond à un relais le relai qui ne transmet que les bits de parité et qui poinçonne les bits systématiques.

Le décodeur BCJR de la figure 12, comme celui de la figure 11, fonctionne sur le corps fini à deux éléments comme le codage canal associé. Seuls les convertisseurs binaire/algébrique et algébrique/binaire ainsi que les operateurs $\sum$ opèrent dans le corps $F_4$.

L'ordonnancement de base d'un récepteur selon l'invention est décrit ci-après dans le cas particulier correspondant à un mode de réalisation des relais selon lequel les bits systématiques sont poinçonnés aux relais.

1/Le détecteur MAPD-EI reçoit en entrée les extrinsèques multiplexées des bits systématiques et de parité respectivement des deux sources. Ainsi, il reçoit $E_1 = [E_{s_1} + \Pi_1^{-1} E_{S_1 R_1} + \Pi_2^{-1} E_{S_1 R_2} \, , \, \boldsymbol{E}_{p_1}]$ et $E_2 = [\boldsymbol{E}_{S_2} + \Pi_1^{-1} E_{S_2 R_1} + \Pi_2^{-1} E_{S_2 R_2} \, , \, \boldsymbol{E}_{p_2} \;]$. Il fournit en sortie les LLR de chacune des séquences de bits reçue des deux sources $[L_{s_1}, L_{p_1}]$ et $[L_{s_2}, L_{p2}]$.

2/Le détecteur MAPD-E1I reçoit en entrée les extrinsèques sur les bits de parité des deux relais $\boldsymbol{E}_{pR1}$ et $\boldsymbol{E}_{pR2}$. Il fournit en sortie les LLR de ces mêmes séquences $\boldsymbol{L}_{pR1}$ et $\boldsymbol{L}_{pR2}$.

3/Les décodeurs SISO1 et SISO2 reçoivent en entrée les LLR des bits systématiques et de parité respectivement des deux sources associées issus des détecteurs, ainsi que les extrinsèques sur leurs bits systématiques respectifs issues des décodeurs algébriques SISO Alg1 et SISO Alg2. Ces extrinsèques constituent des informations à priori sur les bits systématiques des deux sources. Ainsi, SISO1 reçoit $\boldsymbol{L}_{p_1}$ et $\boldsymbol{L}_{s_1}$ du détecteur MAPD-EI et reçoit en tant qu'information à priori sur les bits systématiques : $\Pi_1^{-1} E_{S_1 R_1} + \Pi_2^{-1} E_{S_1 R_2}$. Il calcule les LLRs : $\Lambda_{s_1}$ et $\Lambda_{p_1}$ et en déduit, avec $\boldsymbol{L}_{s_1}$ et $\boldsymbol{L}_{p_1}$, les extrinsèques $\boldsymbol{E}_{s_1}$ et $\boldsymbol{E}_{p_1}$ qu'il fournit en sortie. SISO2 est symétrique de SISO1.

4/Le SISO Alg1 est alors activé. Il reçoit en entrée les extrinsèques sur les bits systématiques des sources $S_1$ et $S_2$ fournies par les deux décodeurs canal SISO1 et SISO2 ainsi que les extrinsèques calculées à l'itération précédente par le décodeur SISOAlg2 : $\Pi_1 \left( \boldsymbol{E}_{s_1} + \Pi_2^{-1} . \boldsymbol{E}_{S_1 R_2} \right)$ et $\Pi_1 \left( \boldsymbol{E}_{S_2} + \Pi_2^{-1} . \boldsymbol{E}_{S_2 R_2} \right)$. Il reçoit en outre en entrée les informations a priori sur ces bits systématiques générées par le détecteur multi utilisateurs MAPD-EI : $\Pi_1 . \boldsymbol{L}_{s_1}$ et $\Pi_1 . \boldsymbol{L}_{s_2}$. Il reçoit en outre en entrée les LLR des bits de parité venant premier relai $R_1$ fournis par le détecteur MAPD-EII, $\boldsymbol{L}_{pR1}$. Le décodeur fournit en sortie les extrinsèques sur les bits de parité du relai $R_1$, $\boldsymbol{E}_{pR_1}$, ainsi que sur les bits systématiques des sources $S_1$ et $S_2$ : $\boldsymbol{E}_{s_1 R_1}$ et $\boldsymbol{E}_{s_2 R_1}$. Les décodeurs SISO Alg2 et SISO Alg1 sont symétriques dans leur fonctionnement mais contiennent chacun un décodeur spécifique à leurs opérations algébriques respectives. La fourniture des extrinsèques sur les bits de parité du relai $R_2$, $\boldsymbol{E}_{pR_2}$, ainsi que sur les bits systématiques des sources $S_1$ et $S_2$ : $\boldsymbol{E}_{s_1 R_2}$ et $\boldsymbol{E}_{s_2 R_2}$ par le décodeur SISO Alg2 termine la première itération.

Le retour à l'étape de détection 1/ marque le début de l'itération suivante.

A la fin du processus itératif, le procédé prélève en sortie des décodeurs et des détecteurs d'une part $L_{s1} + \boldsymbol{E}_{s_1} + \Pi_1^{-1} E_{S_1 R_1} + \Pi_2^{-1} E_{S_1 R_2} \lessgtr 0$ pour procéder à la décision sur $\hat{u}_1$ et d'autre part $L_{s2} + \boldsymbol{E}_{s_2} + \Pi_1^{-1} E_{S_2 R_1} + \Pi_2^{-1} E_{S_2 R_2} \lessgtr 0$ pour procéder à la décision sur $\hat{u}_2$. Le signe $\lessgtr$ signifie que si la sortie est positive alors la décision est que $\hat{u}_1$, ou $\hat{u}_2$ vaut un et que si la sortie est négative alors la décision est que $\hat{u}_1$, ou $\hat{u}_2$ vaut zéro.

Les exemples suivants permettent d'illustrer l'utilisation par le récepteur destinataire de l'information transmise « dans la bande » par les relais. Cette information indique quels sont les messages détectés sans erreur par les relais. A partir de cette information, le récepteur déconnecte ou pas un décodeur algébrique d'un décodeur SISO associé à une source, voire désactive un décodeur algébrique.

Premier cas illustré par la figure 13 : un des deux relais, le relais $R_2$, n'envoie qu'un seul signal source, le signal $u_2$. Dans ce cas, le décodeur SISO algébrique SISO alg2 correspondant au relais $R_2$ est déconnecté du décodeur SISO SISO1 de la source $S_1$ non codée.

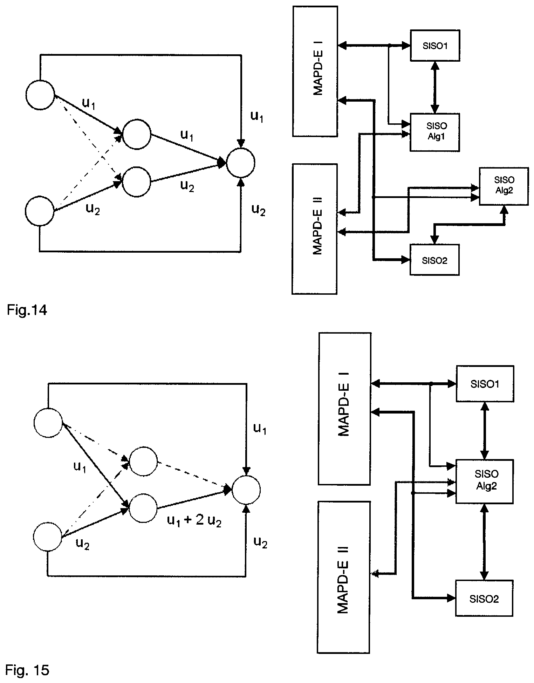

Deuxième cas illustré par la figure 14 : chaque relais $R_1$, $R_2$ envoie uniquement un signal source. Le SISO$i$ est alors déconnecté du décodeur SISO Alg$j$ où i est l'indice de la source $S_i$ non codée par le relai $R_j$.

Troisième cas illustré par la figure 15 : un des deux relais, le relais $R_1$, n'envoie aucun signal source. Dans ce cas, le décodeur SISO algébrique SISO alg1 correspondant au relais $R_1$ est désactivé.

Annexe A

A.1 Corps $F_4$

Le polynôme primitif à l'origine des éléments de ce corps est $X^2 + X + 1$. Soient $\alpha$ et $\alpha^2$ les deux racines de ce polynôme, et notons respectivement 0 et 1 les éléments neutres respectivement de l'addition et de la multiplication pour ce corps. Nous utilisons une notation décimale pour ces éléments : {0, 1, 2, 3} où 2 respectivement 3 représentent $\alpha$ respectivement $\alpha^2$.

| (+) | 0 | 1 | 2 | 3 |
|---|---|---|---|---|
| 0 | 0 | 1 | 2 | 3 |
| 1 | 1 | 0 | 3 | 2 |
| 2 | 2 | 3 | 0 | 1 |
| 3 | 3 | 2 | 1 | 0 |

| (×) | 0 | 1 | 2 | 3 |
|---|---|---|---|---|
| 0 | 0 | 0 | 0 | 0 |
| 1 | 0 | 1 | 2 | 3 |
| 2 | 0 | 2 | 3 | 1 |
| 3 | 0 | 3 | 1 | 2 |

**Tableau 1:  a) Table d'addition de $F_4$         b) Table de multiplication de $F_4$**

Soient $x_1$, $x_2$ et $y$ trois éléments de $F_4$ tels que : $x_1 + 2.x_2 = y$. Les transformations qui permettent de déterminer $x_1$ et $x_2$ sont données par :

$$\begin{cases} x_1 = y + 2.x_2 \\ x_2 = 3.y + 3.x_1 \end{cases}$$

Notons $S_{n,m,i}$ l'ensemble des couples $(k,l)$ de $F_4$ solutions de l'équation donnée par: $n.k + m.l = i$. Ainsi : $S_{n,m,i} = \{(k,l) \in (F_4)^2, n.k + m.l = i\}$

Notons $\Sigma_{n,m,i}$ la fonction définie par :

$$\mathbb{R}^4 \times \mathbb{R}^4 \rightarrow \mathbb{R}$$

$$(\boldsymbol{x}, \boldsymbol{y}) \rightarrow \mathrm{Log} \left( \frac{\sum_{(k,l) \in S_{n,m,i}} Exp(x_k + y_l)}{\sum_{(k,l) \in S_{n,m,0}} Exp(x_k + y_l)} \right)$$

A.2 Grandeurs algébriques

A.2.1 LLR

Le LLR (« Log Likelihood Ratio ») représente le logarithme du rapport de vraisemblance ou rapport de probabilités relatif à deux symboles.

Dans le cas binaire, un bit $u$ peut valoir 1 ou 0. Un tel rapport est donné par un scalaire :

$$LLR = \log\left(\frac{P(u = 1)}{P(u = 0)}\right)$$

et définit de manière unique la décision dure sur le bit $u$ de par son signe.

Dans le cas algébrique, dans $F_4$ par exemple, un symbole $u$ peut prendre quatre valeurs différentes. Un LLR scalaire ne peut pas désigner de manière unique le symbole $\boldsymbol{u}$. Nous introduisons donc un vecteur LLR, de taille quatre définie ainsi :

$$\forall \, q \in F_4 \,, \quad LLR_q \,(u) = \log\left(\frac{P(u=q)}{P(u=0)}\right)$$

La première composante est nulle car u=0 est considéré l'événement de référence par rapport auquel on calcule la vraisemblance des autres événements.

A.2.2 LAPPR

Le LAPPR (« Log A Posteriori Probability Ratio ») désigne une forme de LLR « conditionnel » à une information parallèle (« side information ») fournie typiquement par une séquence reçue.
Dans le cas binaire, le LAPPR est défini par :

$$LAPPR = \log\left(\frac{P(u=1\,|\boldsymbol{y})}{P(u=0|\boldsymbol{y})}\right)$$

Dans le cas algébrique, dans $F_4$ par exemple, nous introduisons un vecteur LAPPR, de taille quatre défini ainsi :

$$\forall \, q \in F_4 \,, \quad LAPPR_q \,(u) = \log\left(\frac{P(u=q\mid \boldsymbol{y})}{P(u=0\mid \boldsymbol{y})}\right)$$

[1] M.Xiao, M.Skoglund, "Design of Network Codes for Multiple Users Multiple Relays Wireless Networks". IEEE International Symposium on Information Theory, 2009.
[2] L.Bahl, J.Cocke, F.Jelinek, and J.Raviv, "Optimal Decoding of Linear Codes for minimizing symbol error rate", IEEE Transactions on Information Theory, vol. IT-20(2), pp.284-287, March 1974

**Revendications**

1. Procédé (1) de transmission semi orthogonal d'un signal destiné à un système à N sources ($S_1$, $S_2$,...$S_N$), M relais ($R_1$,$R_2$,...$R_M$), $R_j$ avec j=1 à M, $M \geq 2$, $N \geq 2$ et un seul récepteur (D) selon lequel la transmission simultanée sur une même ressource spectrale par les relais est successive et non simultanée à une transmission simultanée sur une même ressource spectrale par les sources, le procédé comprenant par relais $R_j$ :

   - une étape (2) de détection/décodage conjoint itératif de messages ($u_1$, $u_2$, ..., $u_N$) émis respectivement par les sources pour obtenir des messages décodés,
   - une étape (3) de détection d'erreurs sur les messages ($u_1$, $u_2$, ..., $u_N$) décodés,
   - une étape (4) d'entrelacement des seuls messages détectés sans erreur suivie d'une étape (5) de codage réseau algébrique de vecteur $a_j = [a_{1,j}\,a_{2,j}\,...\,a_{N,j}]^T$ consistant en une combinaison linéaire dans un corps fini d'ordre strictement supérieur à deux des messages entrelacés pour obtenir un message codé, les combinaisons linéaires étant indépendantes deux par deux entre les relais du système,
   - une étape (6) de mise en forme comprenant un codage canal pour générer un signal représentatif du message codé réseau.

2. Procédé selon la revendication 1, comprenant en outre une étape (7) de mise en forme d'un signal de contrôle indiquant les messages détectés sans erreur représentés dans le signal représentatif destiné au récepteur (D) du signal.

3. Procédé selon la revendication 1, dans lequel le codage canal est systématique.

4. Procédé selon la revendication 1, dans lequel le codage canal est binaire, comprenant en outre :

   - une étape de conversion binaire à symbole entre l'étape d'entrelacement et l'étape de codage réseau algébrique et
   - une étape de conversion symbole à binaire après l'étape de codage réseau algébrique.

**5.** Procédé selon la revendication 1, dans lequel le corps fini d'ordre strictement supérieur à deux est le corps de Galois d'ordre quatre.

**6.** Procédé selon la revendication 1, dans lequel l'étape de détection d'erreurs est effectuée au moyen de l'exploitation d'une information de redondance de type cyclique associée à un message transmis par une source.

**7.** Procédé selon la revendication 1, dans lequel l'étape de détection/décodage conjoint itératif effectue conjointement une détection multi utilisateurs et un décodage à entrées souples et sorties souples.

**8.** Procédé selon la revendication 1, dans lequel l'étape de détection/décodage conjoint itératif met en œuvre un décodage espace temps.

**9.** Procédé selon la revendication 1, dans lequel l'étape de mise en forme comprend une modulation des messages avant émission et un entrelacement entre le codage canal et la modulation.

**10.** Procédé selon la revendication 1, dans lequel $G$ représente la matrice des M vecteurs de codage réseau des relais, T représente la matrice génératrice systématique $T = [I_N G]$ avec $I_N$ la matrice identité de dimension $N$, dans lequel les composantes des vecteurs de codage réseau sont déterminées par tirage aléatoire indépendant de telle manière que la diversité maximale du système est atteinte.

**11.** Programme d'ordinateur sur un support d'informations, ledit programme comportant des instructions de programme adaptées à la mise en œuvre d'un procédé de transmission selon l'une quelconque des revendications 1 à 10, lorsque ledit programme est chargé et exécuté dans un relais destiné à un système à N sources ($S_1$, $S_2$,...$S_N$), M relais ($R_1$,$R_2$,...$R_M$) et un seul récepteur (D), $M \geq 2$, $N \geq 2$, le relais étant destiné à mettre en œuvre le procédé de transmission.

**12.** Support d'informations comportant des instructions de programme adaptées à la mise en œuvre d'un procédé de transmission selon l'une quelconque des revendications 1 à 10, lorsque ledit programme est chargé et exécuté dans un relais destiné à un système à N sources ($S_1$, $S_2$,...$S_N$), M relais ($R_1$,$R_2$,...$R_M$) et un seul récepteur (D), $M \geq 2$, $N \geq 2$ le relais étant destiné à mettre en œuvre le procédé de transmission..

**13.** Relais (R) destiné à un système semi-orthogonal à N sources ($S_1$, $S_2$,...$S_N$), M relais ($R_1$,$R_2$,...$R_M$), $M \geq 2$, $N \geq 2$, et un seul récepteur (D) pour la mise en œuvre d'un procédé de transmission semi orthogonal selon l'une quelconque des revendications 1 à 10, comprenant :

  - un moyen (JDDj) de détection/décodage conjoint itératif pour séparer les flux provenant des sources et déterminer, par flux, un message représentatif d'un mot de code émis par une source,
  - un moyen (CRCji) de détection d'erreur,
  - un moyen ($\pi$ji) d'entrelacement pour entrelacer les seuls messages détectés sans erreur,
  - un moyen (CRj) de codage réseau algébrique de vecteur $a_j = [a_{1,j}\ a_{2,j} \cdots a_{N,j}]^T$ consistant en une combinaison linéaire dans un corps fini d'ordre strictement supérieur à deux des messages entrelacés, les combinaisons linéaires étant indépendantes deux par deux entre les relais du système,
  - un moyen (MCSj) de mise en forme comprenant un codage de canal des messages issus du codage réseau pour générer un signal représentatif des messages codés réseau.

**14.** Procédé destiné à un système semi-orthogonal à N sources ($S_1$, $S_2$,...$S_N$) et M relais ($R_1$,$R_2$,...$R_M$), $M \geq 2$, $N \geq 2$, comprenant un procédé de transmission selon l'une des revendications 1 à 10, et un procédé de réception comprenant de manière itérative :

  - une première étape de détection multi utilisateurs de messages codés ($u_1$, $u_2$, ..., $u_N$) émis simultanément respectivement par les sources pour obtenir des informations souples ($L(c_{Si})$) sur les messages codés respectivement par les sources,
  - une seconde étape de détection multi utilisateurs de messages codés ($u_1$, $u_2$, ..., $u_M$) émis simultanément respectivement par les relais pour obtenir des informations souples ($L(c_{Rj})$) sur les messages codés par les relais,
  - une première étape de N décodages canal souple en parallèle des messages codés respectivement par les N sources et
  - une seconde étape de M décodages réseau souples algébriques en cascade des messages codés respectivement par les M relais sous contrôle d'une information sur les messages détectés sans erreur par les relais,

la première étape de N décodages canal souple utilise comme informations a priori les informations souples ($L(c_{Si})$) provenant de la première étape de détection pour fournir ($E_{Si}$) des informations souples sur les messages décodés à la seconde étape de M décodages réseau souples algébriques,

la seconde étape de M décodages réseau souples utilise comme informations a priori les informations souples ($L(c_{Si})$) et ($L(c_{Rj})$) provenant de la première et seconde étape de détection pour fournir en retour à la seconde étape de détection des informations souples sur les messages décodés,

la première étape de N décodages canal souple et la seconde étape de M décodages réseau souples se fournissant mutuellement des informations extrinsèques, la fourniture mutuelle étant sous contrôle d'une information provenant des relais identifiant les messages détectés sans erreur par les relais.

**15.** Système semi-orthogonal à N sources ($S_1$, $S_2$,...$S_N$) et M relais ($R_1$, $R_2$,...$R_M$), $M \geq 2$, $N \geq 2$, le système comprenant des moyens pour mettre en œuvre un procédé de transmission selon l'une des revendications 1 à 10, et comprenant :

- un premier moyen (MAPD-DI) de détection conjointe multi utilisateurs pour séparer les flux simultanés de messages codés provenant respectivement des N sources pendant une $1^{ère}$ phase de transmission et pour générer des informations souples sur les messages codés,
- un second moyen (MAPD-DII) de détection conjointe multi utilisateurs pour séparer les flux simultanés de messages codés provenant respectivement des M relais pendant une $2^{nde}$ phase de transmission et pour générer des informations souples sur les messages codés provenant respectivement des relais,
- autant de décodeurs souples (SISOi) en parallèle que de sources pour décoder de manière souple les messages codés respectivement par les sources en utilisant comme informations a priori les informations souples ($L(c_{Si})$) provenant du premier moyen (MAPD-DI) de détection et pour générer ($E_{Si}$) des informations souples sur les messages décodés,
- autant de décodeurs algébriques souples (SISO Algj) fonctionnant en cascade que de relais pour décoder de manière souple les messages codés respectivement par les relais en utilisant comme informations a priori les informations souples ($L(c_{Si})$) et ($L(c_{Rj})$) provenant des premier et second moyens (MAPD-DI, MAPD-DII) de détection et pour fournir en retour au second moyen de détection des informations souples sur les messages décodés,
les N décodeurs canal souples et les M décodeurs algébriques souples se fournissant mutuellement des informations extrinsèques, la fourniture mutuelle étant sous contrôle d'une information provenant des relais identifiant les messages détectés sans erreur par les relais,
- un moyen de prise de décision des décodeurs canal pour obtenir une estimation des messages provenant respectivement des sources.

**Patentansprüche**

**1.** Verfahren (1) zur semiorthogonalen Übertragung eines Signals, das für ein System mit N Quellen ($S_1$, $S_2$, ..., $S_N$), M Relais ($R_1$, $R_2$, ..., $R_M$), $R_j$ mit j = 1 bis M, $M \geq 2$, $N \geq 2$, und einem einzigen Empfänger (D) bestimmt ist, gemäß dem die simultane Übertragung auf demselben spektralen Betriebsmittel durch das Relais nacheinander und nicht simultan mit einer simultanen Übertragung auf demselben spektralen Betriebsmittel durch die Quellen erfolgt, wobei das Verfahren pro Relais $R_j$ Folgendes umfasst:

- einen Schritt (2) des iterativen gemeinsamen Detektierens/Decodierens von Nachrichten ($u_1$, $u_2$, ..., $u_N$), die von den entsprechenden Quellen ausgesendet werden, um decodierte Nachrichten zu erhalten,
- einen Schritt (3) des Detektierens von Fehlern in den decodierten Nachrichten ($u_1$, $u_2$,..., $u_N$),
- einen Schritt (4) des Verschachtelns nur der detektierten Nachrichten ohne Fehler, gefolgt von einem Schritt (5) des algebraischen Gittercodierens mit Vektor $\mathbf{a}_j = [a_{1,j} \, a_{2,j} \cdots a_{N,j}]^T$, der aus einer Linearkombination in einem endlichen Körper mit einer Ordnung streng größer als zwei besteht, der verschachtelten Nachrichten, um eine codierte Nachricht zu erhalten,
wobei die Linearkombinationen zwischen den Relais des Systems paarweise unabhängig sind,
- einen Formungsschritt (6), der eine Kanalcodierung umfasst, um ein Signal zu erzeugen, das die gittercodierte Nachricht repräsentiert.

**2.** Verfahren nach Anspruch 1, das außerdem einen Schritt (7) des Formens eines Steuersignals umfasst, das die detektierten Nachrichten ohne Fehler angibt, die in dem repräsentativen Signal repräsentiert werden, das für den Empfänger (D) des Signals bestimmt ist.

3. Verfahren nach Anspruch 1, wobei die Kanalcodierung systematisch ist.

4. Verfahren nach Anspruch 1, wobei die Kanalcodierung binär ist, das außerdem Folgendes umfasst:

   - einen Schritt des Binär/Symbol-Umsetzens zwischen dem Schritt des Verschachtelns und dem Schritt des algebraischen Gittercodierens und
   - einen Schritt des Symbol/Binär-Umsetzens nach dem Schritt des algebraischen Gittercodierens.

5. Verfahren nach Anspruch 1, wobei der endliche Körper mit einer Ordnung streng größer als zwei der Galois-Körper mit Ordnung vier ist.

6. Verfahren nach Anspruch 1, wobei der Schritt des Detektierens von Fehlern mittels der Auswertung von zyklischen Redundanzinformationen, die einer von einer Quelle übertragenen Nachricht zugeordnet sind, ausgeführt wird.

7. Verfahren nach Anspruch 1, wobei der Schritt des iterativen gemeinsamen Detektierens/Decodierens auf gemeinsame Weise eine Mehrfachanwender-Detektion und eine Decodierung an weichen Eingängen und weichen Ausgängen ausführt.

8. Verfahren nach Anspruch 1, wobei der Schritt des iterativen gemeinsamen Detektierens/Decodierens eine Raum/Zeit-Decodierung ausführt.

9. Verfahren nach Anspruch 1, wobei der Formungsschritt eine Modulation der Nachrichten vor dem Aussenden und eine Verschachtelung zwischen der Kanalcodierung und der Modulation umfasst.

10. Verfahren nach Anspruch 1, wobei G die Matrix von M Vektoren mit Gittercodierung der Relais repräsentiert, T die systematische erzeugende Matrix $T = [I_N G]$ repräsentiert, wobei $I_N$ die Einheitsmatrix mit Dimension $N$ ist, wobei die Komponenten der Gittercodierungsvektoren durch unabhängige Zufallsziehung bestimmt werden, derart, dass die maximale Diversität des Systems erreicht wird.

11. Computerprogramm auf einem Datenträger, wobei das Programm Programmbefehle enthält, die für die Ausführung eines Übertragungsverfahrens nach einem der Ansprüche 1 bis 10 ausgelegt sind, wenn das Programm in ein Relais geladen und darin ausgeführt wird, das für ein System mit N Quellen ($S_1$, $S_2$, ..., $S_N$) M Relais ($R_1$, $R_2$, ..., $R_M$) und einem einzigen Empfänger (D) bestimmt ist, mit M $\geq$ 2, N $\geq$ 2, wobei das Relais dazu bestimmt ist, das Übertragungsverfahren auszuführen.

12. Datenträger, der Programmbefehle enthält, die für die Ausführung eines Übertragungsverfahrens nach einem der Ansprüche 1 bis 10 ausgelegt sind, wenn das Programm in ein Relais geladen und darin ausgeführt wird, das für ein System mit N Quellen ($S_1$, $S_2$, ..., $S_N$), M Relais ($R_1$, $R_2$, ..., $R_M$) und einem einzigen Empfänger (D) bestimmt ist, mit M $\geq$ 2, N $\geq$ 2, wobei das Relais dazu bestimmt ist, das Übertragungsverfahren auszuführen.

13. Relais (R), das für ein semiorthogonales System mit N Quellen ($S_1$, $S_2$, ..., $S_N$), M Relais ($R_1$, $R_2$, ..., $R_N$), mit M $\geq$ 2, N $\geq$ 2, und einem einzigen Empfänger (D) bestimmt ist, um ein semiorthogonales Übertragungsverfahren nach einem der Ansprüche 1 bis 10 auszuführen, das Folgendes umfasst:

   - ein Mittel (JDDj) für das iterative gemeinsame Detektieren/Decodieren, um die Flüsse, die von den Quellen stammen, zu separieren und pro Fluss eine Nachricht zu bestimmen, die ein von einer Quelle gesendetes Codewort repräsentiert,
   - ein Mittel (CRCji) für die Fehlerdetektion,
   - ein Mittel (πji) für die Verschachtelung, um nur die detektierten Nachrichten ohne Fehler zu verschachteln,
   - ein Mittel (CRj) für die algebraische Gittercodierung mit Vektor $\mathbf{a}_j = [a_{1,j}\, a_{2,j} \cdots a_{N,j}]^T$, der aus einer Linearkombination in einem endlichen Körper mit einer Ordnung streng größer als zwei besteht, von verschachtelten Nachrichten, wobei die Linearkombinationen zwischen den Relais des Systems paarweise unabhängig sind,
   - ein Mittel (MCSj) für die Formung, das eine Kanalcodierung der von der Gittercodierung stammenden Nachrichten umfasst, um ein Signal zu erzeugen, das gittercodierte Nachrichten repräsentiert.

14. Verfahren, das für ein semiorthogonales System mit N Quellen ($S_1$, $S_2$, ..., $S_N$) und M Relais ($R_1$, $R_2$, ..., $R_M$), mit M $\geq$ 2, N $\geq$ 2, bestimmt ist, das ein Übertragungsverfahren nach einem der Ansprüche 1 bis 10 und ein Empfangsverfahren umfasst, das seinerseits iterativ Folgendes umfasst:

- einen ersten Schritt des Detektierens codierter Nachrichten ($u_1$, $u_2$, ..., $u_N$) mehrerer Anwender, die simultan von den entsprechenden Quellen ausgesendet werden, um weiche Informationen ($L(c_{Si})$) über die durch die Quellen jeweils codierten Nachrichten zu erhalten,

- einen zweiten Schritt des Detektierens codierter Nachrichten ($u_1$, $u_2$, ..., $u_M$) mehrerer Anwender, die simultan von den entsprechenden Relais ausgesendet werden, um weiche Informationen ($L(c_{Rj})$) über die durch die Relais codierten Nachrichten zu erhalten,

- einen ersten Schritt von parallelen weichen N Kanaldecodierungen von Nachrichten, die jeweils durch die N Quellen codiert sind, und

- einen zweiten Schritt von M weichen algebraischen Gitterdecodierungen in Kaskade der Nachrichten, die jeweils durch die M Relais unter der Steuerung einer Information über die durch die Relais ohne Fehler detektierten Nachrichten codiert werden,

wobei der erste Schritt von N weichen Kanaldecodierungen als a priori-Informationen die weichen Informationen ($L(C_{Si})$), die von dem ersten Detektionsschritt stammen, verwendet, um weiche Informationen ($E_{Si}$) über die decodierten Nachrichten zu dem zweiten Schritt von M weichen algebraischen Gitterdecodierungen zu liefern,

wobei der zweite Schritt von M weichen Gitterdecodierungen als a priori-Informationen die weichen Informationen ($L(c_{Si})$) und ($L(c_{Rj})$), die von dem ersten und dem zweiten Detektionsschritt stammen, verwendet, um weiche Informationen über die decodierten Nachrichten zu dem zweiten Detektionsschritt zurückzuliefern,

wobei sich der erste Schritt von N weichen Kanaldecodierungen und der zweiten Schritt von M weichen Gitterdecodierungen gegenseitig extrinsische Informationen liefern, wobei die gegenseitige Lieferung unter der Steuerung einer Information erfolgt, die von den Relais stammt, die die von den Relais ohne Fehler detektierten Nachrichten identifiziert.

**15.** Semiorthogonales System mit N Quellen ($S_1$, $S_2$, ..., $S_N$) und M Relais ($R_1$, $R_2$, ..., $R_M$), mit $M \geq 2$, $N \geq 2$, wobei das System Mittel für die Ausführung eines Übertragungsverfahrens nach einem der Ansprüche 1 bis 10 umfasst und Folgendes umfasst:

- ein erstes Mittel (MAPD-DI) für die gemeinsame Detektion für mehrere Anwender, um die simultanen Flüsse codierter Nachrichten, die jeweils von den N Quellen stammen, während einer ersten Übertragungsphase zu separieren und um weiche Informationen über die codierten Nachrichten zu erzeugen,

- ein zweites Mittel (MAPD-DII) für die gemeinsame Detektion für mehrere Anwender, um die simultanen Flüsse codierter Nachrichten, die jeweils von den M Relais stammen, während einer zweiten Übertragungsphase zu separieren und um weiche Informationen über die codierten Nachrichten, die jeweils von den Relais stammen, zu erzeugen,

- ebenso viele parallele weiche Decodierer (SISOi) wie Quellen, um die durch die jeweiligen Quellen codierten Nachrichten unter Verwendung als a priori-Informationen der weichen Informationen ($L(c_{Si})$), die von dem ersten Detektionsmittel (MAPD-DI) stammen, auf weiche Art zu decodieren und um weiche Informationen ($E_{Si}$) über die decodierten Nachrichten zu erzeugen,

- ebenso viele weiche algebraische Decodierer (SISO Algj), die in Kaskade arbeiten, wie Relais, um die durch die jeweiligen Relais codierten Nachrichten unter Verwendung als a priori-Informationen der weichen Informationen ($L(c_{Si})$) und ($L(c_{Rj})$), die von den ersten und zweiten Detektionsmitteln (MAPD-DI, MAPD-DII) stammen, auf weiche Art zu decodieren und um an die zweiten Detektionsmittel weiche Informationen über die decodierten Nachrichten zurückzuliefern,

wobei sich die N weichen Kanaldecodierer und die M weichen algebraischen Decodierer gegenseitig extrinsische Informationen liefern, wobei die gegenseitige Lieferung unter der Steuerung einer Information, die von den Relais stammt, die die durch die Relais ohne Fehler detektierten Nachrichten identifizieren, erfolgt,

- ein Mittel zum Ausführen einer Entscheidung über die Kanaldecodierer, um eine Schätzung der Nachrichten, die von den jeweiligen Quellen stammen, zu erhalten.

## Claims

**1.** Method (1) of semi-orthogonal transmission of a signal intended for a system of N sources ($S_1$, $S_2$, ...$S_N$), M relays ($R_1$, $R_2$,...$R_M$), $R_j$ with j=1 to M, $M \geq 2$, $N \geq 2$, and a single receiver (D) according to which the simultaneous transmission on one and the same spectral resource by the relays is successive and non-simultaneous with a simultaneous transmission on one and the same spectral resource by the sources, the method comprising per relay $R_j$:

- a step (2) of iterative joint detection/decoding of messages ($u_1$, $u_2$, ..., $u_N$) emitted respectively by the sources to obtain decoded messages,

- a step (3) of detecting errors in the decoded messages $(u_1, u_2, ..., u_N)$,
- a step (4) of interleaving just the errorless messages detected followed by a step (5) of algebraic network coding of vector $a_j = [a_{1,j}\ a_{2,j}\ ...\ a_{N,j}]^T$ consisting of a linear combination in a finite field of order strictly greater than two of the interleaved messages to obtain a coded message,
the linear combinations being pairwise independent between the relays of the system,
- a step (6) of shaping comprising a channel coding to generate a signal representative of the network coded message.

2. Method according to Claim 1, comprising furthermore a step (7) of shaping a control signal indicating errorless messages detected represented in the representative signal intended for the receiver (D) of the signal.

3. Method according to Claim 1, in which the channel coding is systematic.

4. Method according to Claim 1, in which the channel coding is binary, furthermore comprising:

- a step of binary to symbol conversion between the interleaving step and the algebraic network coding step and
- a step of symbol to binary conversion after the algebraic network coding step.

5. Method according to Claim 1, in which the finite field of order strictly greater than two is the Galois field of order four.

6. Method according to Claim 1, in which the step of detecting errors is performed by means of the utilization of a redundancy information item of cyclic type associated with a message transmitted by a source.

7. Method according to Claim 1, in which the step of iterative joint detection/decoding performs jointly a multiuser detection and a soft inputs and soft outputs decoding.

8. Method according to Claim 1, in which the iterative joint detection/decoding step implements a space time decoding.

9. Method according to Claim 1, in which the shaping step comprises a modulation of the messages before emission and an interleaving between the channel coding and the modulation.

10. Method according to Claim 1, in which G represents the matrix of the M network coding vectors of the relays, T represents the systematic generating matrix $T = [I_N G]$ with $I_N$ being the identity matrix of dimension $N$, in which the components of the network coding vectors are determined by independent random drawing in such a way that the maximum diversity of the system is achieved.

11. Computer program of an information medium, said program comprising program instructions adapted for the implementation of a method of transmission according to any one of Claims 1 to 10, when said program is loaded and executed in a relay intended for a system with N sources $(S_1, S_2, ...S_N)$, M relays $(R_1, R_2, ..., R_M)$ and a single receiver (D), $M \geq 2, N \geq 2,$ the relay being intended to implement the method of transmission.

12. Information medium comprising program instructions adapted for the implementation of a method of transmission according to any one of Claims 1 to 10, when said program is loaded and executed in a relay intended for a system with N sources $(S_1, S_2, ... S_N)$, M relays $(R_1, R_2, ..., R_M)$ and a single receiver (D), $M \geq 2, N \geq 2,$ the relay being intended to implement the method of transmission.

13. Relay (R) intended for a semi-orthogonal system of N sources $(S_1, S_2, ...S_N)$, M relays $(R_1, R_2, ..., R_M)$, $M \geq 2, N \geq 2,$ and a single receiver (D) for the implementation of a method of semi-orthogonal transmission according to any one of Claims 1 to 10, comprising:

- a means (JDDj) of iterative joint detection/decoding to separate the streams originating from the sources and to determine, per stream, a message representative of a code word emitted by a source,
- a means (CRCji) of detecting errors,
- a means ($\pi$ji) of interleaving to interleave just the errorless messages detected,
- a means (CRj) of algebraic network coding of vector $a_j = [a_{1,j}\ a_{2,j}\ ...\ a_{N,j}]^T$ consisting of a linear combination in a finite field of order strictly greater than two of the interleaved messages, the linear combinations being pairwise independent between the relays of the system,
- a means (MCSj) of shaping comprising channel coding of the messages from the network coding to generate a signal representative of the network coded messages.

14. Method intended for a semi-orthogonal system of N sources ($S_1$, $S_2$,...$S_N$) and M relays ($R_1$, $R_2$,...$R_M$) $M \geq 2$, $N \geq 2$, comprising a transmission method according to one of Claims 1 to 10 and a reception method comprising iteratively:

- a first step of multiuser detection of coded messages ($u_1$, $u_2$, ..., $u_N$) emitted simultaneously respectively by the sources to obtain soft information ($L(c_{Si})$) on the messages coded respectively by the sources,
- a second step of multiuser detection of coded messages ($u_1$, $u_2$, ..., $u_N$) emitted simultaneously respectively by the relays to obtain soft information ($L(c_{Rj})$) on the messages coded by the relays,
- a first step of N soft channel decodings in parallel, of messages coded respectively by the N sources and
- a second step of M algebraic soft network decodings in cascade, of the messages coded respectively by the M relays under control of an information item on the errorless messages detected by the relays,
the first step of N soft channel decodings uses as a priori information the soft information ($L(c_{Si})$) originating from the first detection step to provide ($E_{si}$) soft information on the messages decoded in the second step of M algebraic soft network decodings,
the second step of M soft network decodings uses as a priori information the soft information ($L(c_{Si})$) and ($L(c_{Rj})$) originating from the first and second detection step to provide as feedback to the second detection step soft information on the decoded messages,
the first step of N soft channel decodings and the second step of M soft network decodings providing themselves mutually with extrinsic information, the mutual provision being under the control of an information item originating from the relays identifying the errorless messages detected by the relays.

15. Semi-orthogonal system of N sources ($S_1$, $S_2$, ...$S_N$) and M relays ($R_1$. $R_2$, ...$R_M$) $M \geq 2$, $N \geq 2$, the system comprising means for implementing a method of transmission according to one of Claims 1 to 10 and comprising:

- a first means (MAPD-DI) of multiuser joint detection to separate the simultaneous streams of coded messages originating respectively from the N sources during a $1^{st}$ transmission phase and to generate soft information on the coded messages,
- a second means (MAPD-DII) of multiuser joint detection to separate the simultaneous streams of coded messages originating respectively from the M relays during a $2^{nd}$ transmission phase and to generate soft information on the coded messages originating respectively from the relays,
- as many soft decoders (SISOi) in parallel as sources to decode in a soft manner the messages coded respectively by the sources, using as a priori information the soft information ($L(c_{si})$) originating from the first means (MAPD-DI) of detection and to generate ($E_{si}$) soft information on the decoded messages,
- as many soft algebraic decoders (SISO Algj) operating in cascade as there are relays to decode in a soft manner the messages coded respectively by the relays, using as a priori information the soft information ($L(c_{si})$) and ($L(c_{Rj})$) originating from the first and second means (MAPD-DI, MAPD-DII) of detection and to provide as feedback to the second means of detection soft information on the decoded messages,
the N soft channel decoders and the M soft algebraic decoders providing one another mutually with extrinsic information, the mutual provision being under the control of an information item originating from the relays identifying the errorless messages detected by the relays,
- a means of decision taking of the channel decoders to obtain an estimation of the messages originating respectively from the sources.

Fig.1

Fig.2

Fig.6

Fig.3a

Fig.3b

Fig.4

Fig.5

Fig.7

Fig.8

Fig.9

Fig.10

Fig.11

Fig.12

Fig.13

Fig.14

Fig. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Full diversity distributed coding for the multiple access half duplex relay channel. **ATOOSA HATEFI et al.** NETWORK CODING (NETCOD), 2011 INTERNATIONAL SYMPOSIUM ON. IEEE, 25 Juillet 2011, 1-6
- Joint channel-network coding for the semi-orthogonal multiple access relay channe. **FIATEFI A et al.** VEHICULAR TECHNOLOGY CONFERENCE FALL (VTC 2010-FALL), 2010 IEEE 72nd. IEEE, 06 Septembre 2010, 1-5

- **M.XIAO ; M.SKOGLUND.** Design of Network Codes for Multiple Users Multiple Relays Wireless Networks. *IEEE International Symposium on Information Theory,* 2009
- **L.BAHL ; J.COCKE ; F.JELINEK ; J.RAVIV.** Optimal Decoding of Linear Codes for minimizing symbol error rate. *IEEE Transactions on Information Theory,* Mars 1974, vol. 20 (2), 284-287